# EUROPÄISCHE PATENTSCHRIFT

(11) **EP 1 390 295 B1**
(45) Veröffentlichungstag und Bekanntmachung des Hinweises auf die Patenterteilung: **13.10.2010**
(21) Anmeldenummer: 02747314.9
(22) Anmeldetag: 16.05.2002
(51) Int. Cl.: C01B 31/02, H01L 21/3205, G01N 27/12

(54) **NANORÖHREN-ANORDNUNG UND VERFAHREN ZUM HERSTELLEN EINER NANORÖHREN-ANORDNUNG**
NANOTUBE ARRAY AND METHOD FOR PRODUCING A NANOTUBE ARRAY
ENSEMBLE A NANOTUBES ET PROCEDE DE FABRICATION D'UN ENSEMBLE A NANOTUBES

(30) Priorität: 16.05.2001 DE 10123876
(43) Veröffentlichungstag der Anmeldung: 25.02.2004
(73) Patentinhaber: Infineon Technologies AG, 85579 Neubiberg (DE)
(72) Erfinder: GRAHAM, Andrew, 81547 München (DE); HOFMANN, Franz, 80995 München (DE); KRETZ, Johannes, 80538 München (DE); KREUPL, Franz, 80802 München (DE); LUYKEN, Richard Johannes, 81825 München (DE); RÖSNER, Wolfgang, 85521 Ottobrunn (DE)
(74) Vertreter: Dokter, Eric-Michael
(86) Internationale Anmeldenummer: PCT/EP2002/005433
(87) Internationale Veröffentlichungsnummer: WO 2002/092505

(56) Entgegenhaltungen:
- WO-A-01/44796
- US-A1- 2002 014 667
- KONG J ET AL: "SYNTHESIS OF INDIVIDUAL SINGLE-WALLED CARBON NANOTUBES ON PATTERNEDSILICON WAFERS" NATURE, MACMILLAN JOURNALS LTD. LONDON, GB, Bd. 395, 29. Oktober 1998 (1998-10-29), Seiten 878-881, XP000960753 ISSN: 0028-0836
- LI J ET AL: "HIGHLY-ORDERED CARBON NANOTUBE ARRAYS FOR ELECTRONICS APPLICATIONS" APPLIED PHYSICS LETTERS, AMERICAN INSTITUTE OF PHYSICS. NEW YORK, US, Bd. 75, Nr. 3, 19. Juli 1999 (1999-07-19), Seiten 367-369, XP000850812 ISSN: 0003-6951

## Beschreibung

Die Erfindung betrifft eine Nanoröhren-Anordnung und ein Verfahren zum Herstellen einer Nanoröhren-Anordnung.

Die herkömmliche Silizium-Mikroelektronik wird bei weiter voranschreitender Verkleinerung an ihre Grenzen stoßen. Insbesondere die Entwicklung zunehmend kleinerer und dichter angeordneter Transistoren von mittlerweile mehreren Hundertmillionen Transistoren pro Chip wird in den nächsten zehn Jahren prinzipiellen physikalischen Problemen und Begrenzungen ausgesetzt sein. Wenn Strukturabmessungen von 80 nm unterschritten werden, werden die Bauelemente durch Quanteneffekte störend beeinflusst und unterhalb von Dimensionen von etwa 30 nm dominiert. Auch führt die zunehmende Integrationsdichte der Bauelemente auf einem Chip zu einem dramatischen Anstieg der Abwärme.

Als eine mögliche Nachfolgetechnik der herkömmlichen Halbleiterelektronik sind Kohlenstoffnanoröhren bekannt. Eine Übersicht über diese Technologie gibt beispielsweise [1].

Eine Nanoröhre ist eine einwandige oder mehrwandige, röhrenartiger Kohlenstoff-Verbindung. Bei mehrwandigen Nanoröhren ist mindestens eine innere Nanoröhre von einer äußeren Nanoröhre koaxial umgeben. Einwandige Nanoröhren weisen typisch Durchmesser von ungefähr einem Nanometer auf, die Länge einer Nanoröhre kann mehrere hundert Nanometer betragen. Die Enden einer Nanoröhre sind häufig mit jeweils einem halben Fulleren-Molekülteil abgeschlossen.

Das ausgedehnte π-Elektronensystem und die geometrische Struktur von Nanoröhren bewirken eine gute elektrische Leitfähigkeit, weshalb Nanoröhren geeignet für den Aufbau von Schaltkreisen mit Dimensionen im Nanometer-Bereich sind. Aus [2] ist bekannt, dass die elektrische Leitfähigkeit von Kohlenstoffnanoröhren die von Metallen gleicher Abmessung deutlich übersteigen kann.

Der Durchmesser und die Chiralität einer Nanoröhre sind Parameter, von denen die elektrische Leitfähigkeit einer Nanoröhre abhängt. Die elektrische Leitfähigkeit einer Nanoröhre kann ferner durch Anlegen eines elektrischen Feldes und/oder Dotieren der Nanoröhren mit Bornitrid verändert werden. Im letzteren Falle spricht man von einer mit Boratomen und Stickstoffatomen dotierten Nanoröhre oder auch von einer Bornitrid-Nanoröhre.

Aufgrund der Leitfähigkeit von Nanoröhren sowie aufgrund der Einstellbarkeit dieser Leitfähigkeit in der oben genannten Weise eignen sich Nanoröhren für eine große Anzahl von Anwendungen, beispielsweise für die elektrische Verbindungstechnik in integrierten Schaltkreisen, für Bauelemente in der Mikroelektronik sowie für ElektronenEmitter.

Ferner ist aus [3] bekannt, dass der elektrische Widerstand von Nanoröhren sich innerhalb weniger Sekunden um ungefähr drei Größenordnungen ändert, wenn Nanoröhren einem Gas wie beispielsweise einem Stickstoffdioxidgas (NO₂) oder einem Ammoniakgas (NH₃) ausgesetzt werden. In einer NH₃-Atmosphäre wird die elektrische Leitfähigkeit der Nanoröhren herabgesetzt, was mit einer Verschiebung der Valenzbandkante weit unter das Ferminiveau der Nanoröhren und einer hierdurch bewirkten Verarmung von Ladungsträgern erklärt wird. Umgekehrt erhöht sich die elektrische Leitfähigkeit der Nanoröhren um etwa drei Größenordnungen, wenn die Nanoröhren einer NO₂-Atmosphäre in einer Konzentration von etwa 200 ppm ausgesetzt werden. Dies wird damit erklärt, dass die Fermienergie der Nanoröhren näher an das Valenzband verschoben wird und demzufolge die Zahl der Ladungsträger in den Nanoröhren zunimmt.

Für die Verwendung von Nanoröhren in der Mikroelektronik ist es oftmals wünschenswert, Nanoröhren an bestimmte Orte eines Substrats definiert aufzubringen. Beispielsweise können Nanoröhren als Leiter verwendet werden, um zwei voneinander elektrisch getrennte Leiterebenen eines Mikroschaltungselements zu koppeln. Hierfür ist erforderlich, dass Nanoröhren nur dort aufgewachsen werden, wo eine entsprechende elektrische Kopplung angestrebt wird, wohingegen die anderen Bereiche des Substrates frei von Nanoröhren bleiben sollen, um elektrische Kurzschlüsse zu vermeiden.

Um dieses Ziel zu erreichen, ist bekannt, ein das Wachstum von Nanoröhren katalysierendes Metall, beispielsweise Eisen, mit Hilfe eines Sputterverfahrens auf ein etwa mit Photolack strukturiertes Substrat aufzubringen. Anschließend wird unter Verwendung eines Lift-off-Verfahren der strukturierte Photolack und das darauf befindliche Metall entfernt. Dadurch bleibt das Metall-Material nur auf zuvor freigelegten Stellen des Substrats zurück. Das zurückbleibende katalytisch aktive Metall wird als Matrix zum Aufwachsen von Nanoröhren verwendet.

Abscheideverfahren aus der Gasphase ("chemical vapour deposition", CVD) sind als Herstellungsverfahren für Kohlenstoffnanoröhren bekannt. Bei dem CVD-Verfahren werden die Komponenten und Dotierungsstoffe als Gase, gegebenenfalls mit zusätzlichen Trägergasen in einem Reaktionsraum zusammengeführt, und dort erfolgt die Abscheidung auf dem Substrat. Für die Herstellung von Kohlenstoffnanoröhren wird beim CVD-Verfahren häufig Methan (CH₄) oder alternativ Azetylen (C₂H₂) als Kohlenstoffquelle verwendet.

Verfahren zum Herstellen von Nanoröhren sowie Nanodrähten auf katalytisch aktiven Oberflächen unter Verwendung des CVD-Verfahrens sind beispielsweise in [4] und [5] beschrieben. Mit dem dort angegebenen Verfahren lassen sich Kohlenstoffnanoröhren herstellen, die senkrecht auf einem Substrat stehend angeordnet sind.

Bei dem in [4] beschriebenen Verfahren muss die Unterlage allerdings aus Aluminium bestehen. Diese Materialbeschränkung ist nachteilhaft. Ferner ergeben sich gemäß dem in [4] beschriebenen Verfahren relativ große, mehrwandige Kohlenstoffnanoröhren mit Durchmessern von ungefähr 50 nm. Auch sind die gemäß dem beschriebenen Verfahren hergestellten Kohlenstoffnanoröhren senkrecht zu dem Substrat orientiert und daher nur eingeschränkt in herkömmliche Silizium-Mikroelektronik integrierbar.

Gemäß dem in [5] beschriebenen Verfahren zum Herstellen von Kohlenstoffnanoröhren entsteht eine Anordnung von Kohlenstoffnanoröhren in dicht gepackten Blöcken. Diese Blöcke werden durch den mit einer Maske aufgedampften Katalysator (beispielsweise Eisen) definiert. Jedoch ist das Herstellen einer regelmäßigen Anordnung gemäß dem beschriebenen Herstellungsverfahren schwierig. Da wiederum ausschließlich senkrecht zu der Oberfläche des Substrats orientierte Nanoröhren herstellbar sind, sind der Ankopplung der Nanoröhren an herkömmliche Silizium-Mikroelektronik enge Grenzen gesetzt.

Zusammenfassend weisen aus dem Stand der Technik bekannte Herstellungsverfahren einer Anordnung von Kohlenstoffnanoröhren eine Reihe von Nachteilen auf. So sind die gemäß den beschriebenen Verfahren hergestellten Nanoröhren senkrecht zu der Oberfläche des Substrats orientiert. Ferner ist es gemäß den bekannten Verfahren schwierig, strukturell definierte Anordnungen von Nanoröhren herzustellen. Den Nanoröhren auf der Oberfläche eines Katalysatormaterials ist keine exakt definierte Aufwachsrichtung vorgegeben. Der daraus resultierende geringe Ordnungsgrad und die Tatsache, dass die Nanoröhren senkrecht zur Substratoberfläche orientiert sind, führt dazu, dass die aus dem Stand der Technik bekannten Nanoröhren-Anordnungen nur unter Schwierigkeiten oder gar nicht an herkömmliche Silizium-Mikroelektronik ankoppelbar ist.

Aus [6] ist bekannt, auf einem Substrat Katalysatorinseln auszubilden. Unter Verwendung eines CVD-Verfahrens kann eine mit zwei. Katalysatorinseln gekoppelte Kohlenstoffnanoröhre ausgebildet werden, falls eine ausgehend von einer Katalysatorinsel aufwachsende Kohlenstoffnanoröhre zufällig in Richtung einer zweiten Katalysatorinsel aufwächst. Daher ist auch gemäß [6] keine räumlich ausreichend gut definierte Anordnung von Nanoröhren herstellbar.

[7] offenbart eine Nanoröhren-Anordnung, bei der Seitenflächen einer Katalysatorschicht freigelegt sind, indem eine Öffnung in dem beschichteten Substrat gebildet wird.

[8] offenbart Inseln aus Katalysatormaterial von denen ausgehend sich Nanoröhren bilden.

Der Erfindung liegt das Problem zugrunde, eine räumlich gut definierte Anordnung planar orientierter Nanoröhren bereitzustellen.

Das Problem wird durch eine Nanoröhren-Anordnung und ein Verfahren zum Herstellen einer Nanoröhren-Anordnung mit den Merkmalen gemäß den unabhängigen Patentansprüchen gelöst.

Eine Nanoröhren-Anordnung weist auf ein Substrat, eine Katalysatorschicht, die einen oder mehrere Teilbereiche aufweist, auf der Oberfläche des Substrats und mindestens eine parallel zur Oberfläche des Substrats auf der Oberfläche der Katalysatorschicht angeordnete Nanoröhre.

Indem die mindestens eine Nanoröhre parallel zur Oberfläche des Substrats angeordnet ist, ist eine planare Anordnung mindestens einer Nanoröhre realisiert. Daher ist die Nanoröhren-Anordnung der Erfindung geeignet zum Ankoppeln an herkömmliche Silizium-Mikroelektronik. Daher ist erfindungsgemäß eine elektronische Ankopplung einer Nanoröhren-Anordnung an eine makroskopische Halbleiterelektronik ermöglicht.

Ferner kann die erfindungsgemäße Nanoröhren-Anordnung eine elektrisch isolierende Schicht zwischen dem Substrat und der Katalysatorschicht aufweisen. Diese elektrisch isolierende Schicht weist vorzugsweise eine derartige Topographie auf, dass die mindestens eine Nanoröhre in ihren Endabschnitten auf der elektrisch isolierenden Schicht aufliegt und in ihrem Mittenabschnitt freiliegt.

Indem die Oberfläche der mindestens einen Nanoröhre teilweise freiliegt, kann die freiliegende Oberfläche der Nanoröhre als aktive Sensoroberfläche verwendet werden. Beispielsweise kann die freiliegende Oberfläche der Nanoröhre in Wirkkontakt mit einer die Nanoröhren-Anordnung umgebenden Atmosphäre gelangen. Wie oben ausgeführt, ändert sich in der Anwesenheit bestimmter Gase (beispielsweise NO₂ oder NH₃) der elektrische Widerstand einer Nanoröhre signifikant, so dass infolge des Freiliegens der Nanoröhre die Nanoröhren-Anordnung in vielen Anwendungen in der Sensorik eingesetzt werden kann.

Ferner können bei der Nanoröhren-Anordnung die Teilbereiche der Katalysatorschicht voneinander elektrisch entkoppelt sein. Auch können unabhängig davon die Nanoröhren der Anordnung voneinander elektrisch entkoppelt sein.

Indem die Nanoröhren-Anordnung mehrere voneinander elektrisch entkoppelte Teilbereiche der Katalysatorschicht bzw. mehrere voneinander elektrisch entkoppelte Nanoröhren aufweist, ist es möglich, mehrere Nanoröhren parallel und unabhängig voneinander als Bauelemente für einen elektrischen Schaltkreis (beispielsweise als elektrische Leiter) und/oder als Sensoren zu verwenden.

Die voneinander entkoppelten Nanoröhren sind gemäß der Nanoröhren-Anordnung der Erfindung planar vorgesehen, d.h. sie sind parallel zu der Oberflächenebene des Substrats angeordnet. Vorzugsweise sind sie parallel zueinander und jeweils in einem Abstand voneinander angeordnet. Diese Anordnung erhöht die mechanische Stabilität der Nanoröhren, da Letztere in horizontaler Richtung angeordnet sind, so dass anschaulich ein Abknicken der empfindlichen Nanoröhren vermieden ist. Dagegen stehen gemäß dem Stand der Technik Nanoröhren senkrecht aus einer Substratoberfläche hervor und sind daher mechanischen Störungen ausgesetzt. Die Nanoröhren-Anordnung der Erfindung ist mechanisch ausreichend robust, um unter Laborbedingungen eingesetzt werden zu können.

Die Nanoröhren-Anordnung kann ferner eine Schaltkreiseinrichtung aufweisen, mittels derer die Nanoröhren einzeln ansteuerbar und/oder auslesbar sind. So kann beispielsweise mittels der Schaltkreiseinrichtung der elektrische Widerstand jeder der Nanoröhren einzeln erfasst werden. Die Schaltkreiseinrichtung kann eine herkömmliche mikroelektronische Schaltung sein. Damit ist die Ankopplung einer Nanoröhren-Anordnung an einen herkömmlichen mikroelektronischen Schaltkreis realisiert. Die planare, horizontale Anordnung der Nanoröhren ist für die Integration in Silizium-Mikroelektronik besonders gut geeignet. Insbesondere kann die Mikroelektronik als integrierter Schaltkreis in dem Substrat vorgesehen sein, auf dem auch die mindestens eine Nanoröhre angeordnet ist.

Ferner kann mindestens einer der Teilbereiche der Katalysatorschicht zumindest teilweise von einer weiteren elektrisch isolierenden Schicht umgeben sein. Insbesondere kann die elektrisch isolierende Schicht und die weitere elektrisch isolierende Schicht, zwischen denen die Katalysatorschicht angeordnet ist, seitlich über die Katalysatorschicht hinausstehen, um so eine Pore auszubilden, durch welche Pore die zur Oberfläche des Substrats parallele Aufwachsrichtung der Nanoröhre vorgebbar ist. Anschaulich dient die waagerechte Pore als Schablone für das Wachstum der Nanoröhre. Die Pore wird ausgebildet durch zwei beidseitig über die Katalysatorschicht hinausstehenden Wände, die durch die elektrisch isolierende Schicht und durch die weitere elektrisch isolierende Schicht ausgebildet werden. Durch die erste elektrisch isolierende Schicht und die zweite elektrisch isolierende Schicht wird ein Großteil der Oberfläche der Katalysatorschicht bedeckt, und es verbleibt nur ein kleiner Oberflächenbereich der Katalysatorschicht freiliegend. Dieser freiliegende Oberflächenbereich ist senkrecht zur Substratoberfläche orientiert. Lässt man auf dieser Oberfläche der Katalysatorschicht eine Nanoröhre aufwachsen, so ist die Aufwachsrichtung durch die Geometrie der Anordnung vorgegeben. Die Aufwachsrichtung der Kohlenstoffnanoröhre erfolgt senkrecht zur freiliegenden Oberfläche der Katalysatorschicht. Daher ist die Aufwachsrichtung der Nanoröhre horizontal, d.h. die Nanoröhre wächst in einer zu der Oberfläche des Substrats parallelen Richtung auf. Durch die beidseitig über die Katalysatorschicht überstehenden ersten und zweiten elektrisch isolierenden Schichten ist der Nanoröhre für den Aufwachsvorgang eine mechanische Führung gegeben, so dass das Aufwachsen in horizontaler Richtung parallel zur Oberfläche des Substrats erfolgt. Indem die Aufwachsrichtung durch die Geometrie der Poren vorgebbar ist, ist eine definierte Struktur von Kohlenstoffnanoröhren realisierbar. Dieser hohe Grad an struktureller Definiertheit ist vorteilhaft bei der Ankopplung der Nanoröhren-Anordnung an eine herkömmliche Silizium-Mikroelektronik.

Ferner ist vorteilhaft, dass durch die erfindungsgemäße Nanoröhren-Anordnung einzelne Nanoröhren, und nicht wie gemäß dem Stand der Technik Büschel mit Durchmessern im Bereich von 50 nm bereitgestellt sind. Durch periodische Anordnung von Poren ist auch eine periodische Anordnung von Nanoröhren realisierbar. Es ist diesbezüglich zu betonen, dass die Ausdehnung der Pore ausreichend klein wählbar ist, so dass in bzw. aus einer Pore nur eine einzige Nanoröhre aufwächst. Vorzugsweise sind die elektrisch isolierende Schicht und/oder die weitere elektrisch isolierende Schicht voneinander unabhängig aus einem oder einer Kombination der Materialien Siliziumnitrid und Siliziumdioxid hergestellt. Da diese Materialien für das Aufwachsen von Nanoröhren nicht katalytisch wirken, ist durch die Wahl dieser Materialien sichergestellt, dass jede Nanoröhre in einem räumlich genau definierten Bereich im Inneren der Pore, d.h. auf der Oberfläche der Katalysatorschicht aufwächst.

Auch kann bei der Nanoröhren-Anordnung der Erfindung mindestens einer der Teilbereiche der Katalysatorschicht zumindest teilweise von einer Schicht zur Verhinderung von Diffusion umgeben sein. Anschaulich verhindert diese Schicht zur Verhinderung von Diffusion, welche mindestens einen der Teilbereiche der Katalysatorschicht zumindest teilweise umgibt, dass Katalysatormaterial in benachbarte Schichten eindiffundiert bzw. das Material von den benachbarten Schichten in die Katalysatorschicht eindiffundiert. Insbesondere ist bekannt, dass katalytisch aktive Metalle die Neigung haben, in Silizium-Schichten beispielsweise eines angeschlossenen Schaltkreises einzudiffundieren. Durch die Schicht zur Verhinderung von Diffusion ist die Lebensdauer der Nanoröhren-Anordnung erhöht und ihre Funktionsweise sichergestellt. Vorzugsweise ist die Schicht zur Verhinderung von Diffusion aus Tantalnitrid-Material hergestellt.

Die Katalysatorschicht ist vorzugsweise aus einem oder einer Kombination der Materialien Nickel, Eisen und Kobalt hergestellt. Alternativ kann jedes andere geeignete Material, insbesondere jedes andere Metall, verwendet werden, welches das Wachstum von Nanoröhren katalysiert.

Vorzugsweise sind die Teilbereiche der Katalysatorschicht auf der Oberfläche des Substrats zueinander parallel angeordnet. Durch diese parallele Anordnung ist die Ausbildung parallel angeordneter Poren ermöglicht.

Die Nanoröhren-Anordnung kann als Gassensor verwendet werden. Für diesen Anwendungszweck ist eine Nanoröhre mit im Wesentlichen freiliegender Oberfläche erforderlich. Zwei Elektroden sind über die mindestens eine Nanoröhre elektrisch gekoppelt. Zum Zwecke der mechanischen Stabilisierung können die Endabschnitte der mindestens einen Kohlenstoffnanoröhre auf einer mechanisch robusten Oberfläche, beispielsweise einer elektrisch isolierenden Schicht, angeordnet sein. Die beschriebene Nanoröhren-Anordnung kann auf einem Substrat, beispielsweise einem Silizium-Wafer, aufgebracht sein. Zwischen den beiden Elektroden kann durch ein Mittel zum Erfassen des elektrischen Widerstandes der Widerstand der mindestens einen Nanoröhre erfasst werden.

Die Verwendung der Nanoröhren-Anordnung als Gassensor macht sich den oben beschriebenen physikalischen Effekt zunutze, dass sich der elektrische Widerstand von Nanoröhren innerhalb weniger Sekunden um etwa drei Größenordnungen ändert, wenn eine Nanoröhre einer Gasatmosphäre, wie beispielsweise Stickstoffoxid (NO₂) oder Ammoniak (NH₃), ausgesetzt ist. Es ist zu betonen, dass die als Gassensor verwendete Nanoröhren-Anordnung der Erfindung nicht auf das Detektieren der beiden genannten Gase beschränkt ist, ferner können auch andere Gase wie Sauerstoff (O₂) nachgewiesen werden, deren Anwesenheit zu einer Änderung des elektrischen Widerstandes der Nanoröhren führt. Mit der Nanoröhren-Anordnung der Erfindung ist ein ausreichend robuster und empfindlicher, auf spezifische Gase selektiv sensitiver Gassensor bereitgestellt.

Es sei noch hinzugefügt, dass die beiden elektrisch leitfähigen Elektroden sowie die Nanoröhren beispielsweise auf einem Halbleiterchip, z.B. einem CMOS-Chip integriert sein können. Das Mittel zum Erfassen des elektrischen Widerstandes kann beispielsweise ein Ohmmeter sein.

Die Nanoröhren in der Nanoröhren-Anordnung können Kohlenstoffnanoröhren sein.

Die Schritte des Verfahrens zum Herstellen einer Nanoröhren-Anordnung werden im Weiteren zum Zwecke der Klarheit mit Großbuchstaben bezeichnet.

In einem Schritt B des Verfahrens wird eine Katalysatorschicht auf der Oberfläche der Schichtanordnung aufgebracht, wobei die Katalysatorschicht einen oder mehrere Teilbereiche aufweist.

In einem Schritt F wird mindestens eine Nanoröhre auf einem freiliegenden Teil der Oberfläche eines Teilbereichs der Katalysatorschicht aufgewachsen, derart, dass die mindestens eine Nanoröhre parallel zur Oberfläche der Schichtanordnung angeordnet wird.

Ferner kann bei dem Verfahren zur Herstellung einer Nanoröhren-Anordnung in einem weiteren Schritt A die bei Schritt B genannte Schichtanordnung durch Aufbringen einer elektrisch isolierenden Schicht auf einem Substrat ausgebildet werden.

Auch kann in einem Schritt C eine weitere elektrisch isolierende Schicht auf mindestens einem Teil der Oberfläche der Schichtanordnung aufgebracht werden, derart, dass die weitere elektrisch isolierende Schicht mindestens einen der Teilbereiche der Katalysatorschicht mindestens teilweise bedeckt.

Darüber hinaus kann in einem Schritt D ein Graben in einen Oberflächenbereich der Schichtanordnung geätzt werden.

In einem Schritt E kann die Katalysatorschicht teilweise zurückgeätzt werden, derart, dass die elektrisch isolierende Schicht und die weitere elektrisch isolierende Schicht seitlich über die Katalysatorschicht hinausstehen, so dass eine Pore als Führung für das Aufwachsen der Nanoröhre erzeugt wird, durch welche die zur Oberfläche des Substrats parallele Aufwachsrichtung der Nanoröhren vorgegeben wird.

In einem Schritt F wird mindestens eine Nanoröhre auf einem freiliegenden Teil der Oberfläche eines Teilbereichs der Katalysatorschicht aufgewachsen, derart, dass die mindestens eine Nanoröhre parallel zur Oberfläche der Schichtanordnung angeordnet wird.

Gemäß einer bevorzugten Ausgestaltung des erfindungsgemäßen Verfahrens zum Herstellen einer Nanoröhren-Anordnung werden die oben genannten Schritte A bis F in der folgenden Reihenfolge ausgeführt:
Zunächst wird in Schritt A eine Schichtanordnung durch Aufbringen einer elektrisch isolierenden Schicht auf einem Substrat ausgebildet. Dann wird in einem nachfolgenden Schritt B eine Katalysatorschicht auf der Oberfläche der Schichtanordnung aufgebracht, wobei die Katalysatorschicht einen oder mehrere Teilbereiche aufweist. Anschließend wird in einem weiteren Schritt C eine weitere elektrisch isolierende Schicht auf mindestens einen Teil der Oberfläche der Schichtanordnung aufgebracht, derart, dass die weitere elektrisch isolierende Schicht mindestens einen der Teilbereiche der Katalysatorschicht teilweise bedeckt. Danach wird in einem Schritt D ein Graben in einen Oberflächenbereich der Schichtanordnung geätzt. In einem nachfolgenden Schritt E wird die Katalysatorschicht teilweise zurückgeätzt, derart, dass die elektrisch isolierende Schicht und die weitere elektrisch isolierende Schicht seitlich über die Katalysatorschicht hinausstehen, so dass eine Pore erzeugt wird, durch welche die zur Oberfläche des Substrats parallele Aufwachsrichtung der Nanoröhre vorgegeben wird. In einem Schritt F wird dann mindestens eine Nanoröhre auf einem freiliegenden Teil der Oberfläche eines Teilbereichs der Katalysatorschicht aufgewachsen, derart, dass die mindestens eine Nanoröhre parallel zur Oberfläche der Schichtanordnung angeordnet wird.

Anschaulich wird in Schritt A eine elektrisch isolierende Schicht auf einem Substrat ausgebildet. Insbesondere kann dies durch Abscheiden von Siliziumnitrid-Material auf einem Silizium-Wafer geschehen. In Schritt B wird eine Katalysatorschicht auf der Oberfläche der Schichtanordnung aufgebracht, wobei die Katalysatorschicht einen oder mehrere Teilbereiche aufweist. Dies kann realisiert werden, indem eine als Katalysatorschicht geeignete Nickel-Schicht in einer Dicke von ungefähr 20 nm auf der Oberfläche der Siliziumnitrid-Schicht abgeschieden wird und diese Nickel-Schicht unter Verwenden des Verfahrens der Elektronenstrahllithographie zu vorzugsweise im Wesentlichen parallel zueinander verlaufenden Drähten von ungefähr 20 nm Breite strukturiert wird. In dem nachfolgenden Schritt C wird eine weitere elektrische isolierende Schicht auf mindestens einem Teil der Oberfläche der Schichtanordnung derart aufgebracht, dass die weitere elektrische isolierende Schicht mindestens einen der Teilbereiche der Katalysatorschicht mindestens teilweise bedeckt. Hierzu kann beispielsweise Siliziumdioxid-Material auf der Oberfläche der Schichtanordnung abgeschieden werden und mittels eines Photolithographie-Verfahrens strukturiert werden, so dass die weitere elektrisch isolierende Schicht nur noch auf einem Teil der Oberfläche der Schichtanordnung verbleibt. Insbesondere überdeckt die weitere elektrisch isolierende Schicht zumindest teilweise die Katalysatorschicht. In dem weiteren Schritt D wird ein Graben in einen Oberflächenbereich der Schichtanordnung geätzt. Dies kann realisiert werden, indem mittels eines Photolithographie-Verfahrens der freiliegende Bereich der elektrisch isolierenden Schicht teilweise zurückgeätzt wird. In einem weiteren Schritt E wird die Katalysatorschicht teilweise zurückgeätzt, derart, dass die elektrisch isolierende Schicht und die weitere elektrisch isolierende Schicht beidseitig über die Katalysatorschicht hinausstehen, so dass eine Pore erzeugt wird, durch welche die zur Oberfläche des Substrats parallele Aufwachsrichtung der Nanoröhre vorgegeben wird. Dieser Verfahrensschritt kann dadurch realisiert werden, dass die Nickel-Schicht nasschemisch zurückgeätzt wird und so Poren erzeugt werden. Diese Poren entstehen anschaulich dadurch, dass die Nickelschicht entlang einer Richtung parallel zur Substratoberfläche so weit zurückgeätzt wird, dass sowohl die unterhalb der Nickel-Schicht angeordnete Siliziumnitrid-Schicht als auch die oberhalb der Nickel-Schicht angeordnete Siliziumdioxid-Schicht in seitlicher Richtung oberhalb und unterhalb der Nickel-Schicht über Letztere hinausstehen. In einem Schritt F wird dann mindestens eine Nanoröhre auf einem freiliegenden Teil der Oberfläche eines Teilbereichs der Katalysatorschicht aufgewachsen, derart, dass die mindestens eine Nanoröhre parallel zur Oberfläche der Schichtanordnung angeordnet wird. Das Aufwachsen der Nanoröhren kann beispielsweise unter Verwendung des Gasphasenepitaxie-Verfahrens realisiert werden. Das Verfahren zum Herstellen einer Nanoröhren-Anordnung weist eine Reihe von Vorteilen auf. Durch eine Kombination von halbleitertechnologischen Nanostrukturtechniken und einer Technik zum Aufwachsen von Nanoröhren sind geometrisch geordnete Strukturen von planar angeordneten Nanoröhren herstellbar. Die Einzelschritte des Verfahrens beruhen wie oben beschrieben auf ausgereiften, standardisierten halbleitertechnologischen Prozessen. Daher ist zum Ausführen des erfindungsgemäßen Verfahrens zum Herstellen der Nanoröhren-Anordnung eine Neuentwicklung von Anlagen entbehrlich. Dies ist zeit- und kostensparend.

Ein großer Vorteil des erfindungsgemäßen Verfahrens besteht darin, dass durch die oben beschriebene Porengeometrie das Herstellen von Nanoröhren hinsichtlich Dimension und Wachsrichtung exakt vorgebbar ist. Die Querschnittsfläche einer Nanoröhre ist durch die Dimension der freiliegenden Katalysatoroberfläche festgelegt, da nur von einem katalytisch aktiven Material aus das Nanoröhren-Wachstum beginnen kann. Die bevorzugte Wachstumsrichtung einer Nanoröhre ist erfindungsgemäß bereits durch den Normalenvektor der freiliegenden Katalysatoroberfläche vorgegeben, und wird zusätzlich durch die beidseitig der Katalysatorschicht angeordneten elektrisch isolierenden Schichten stabilisiert. Damit ist der Nanoröhre beim Aufwachsen eine mechanische Führung gegeben, so dass die Nanoröhre in vorgebbarer Richtung parallel zu der Oberfläche des Substrats aufwächst.

Ferner kann die Dicke der Katalysatorschicht erfindungsgemäß genau eingestellt werden. Gemäß dem oben beschriebenen Beispiel ist die Dicke der Katalysatorschicht beispielsweise ungefähr 20 nm. Indem die Dicke ausreichend klein gewählt wird, ist sichergestellt, dass auf der Pore nur eine einzige Nanoröhre aufwachsen kann.

Gemäß einer anderen Ausgestaltung des erfindungsgemäßen Verfahrens zum Herstellen einer Nanoröhren-Anordnung ist die Reihenfolge der oben einzeln beschriebenen Schritte gegenüber dem zuvor beschriebenen Ausführungsbeispiel verändert. Der oben mit D bezeichnete Schritt wird gemäß dem hier beschriebenen Ausführungsbeispiel nach dem Schritt A und vor dem Schritt B ausgeführt. Im einzelnen werden die Schritte in folgender Reihenfolge ausgeführt:
Zunächst wird in Schritt A eine Schichtanordnung durch Aufbringen einer elektrisch isolierenden Schicht auf einem Substrat ausgebildet. Dieser Schritt kann realisiert werden, indem eine Siliziumnitrid-Schicht auf einem Silizium-Wafer abgeschieden wird. In einem nachfolgenden Schritt D wird ein Graben in einen Oberflächenbereich der Schichtanordnung geätzt. Dies kann durch Photostrukturieren der aufgebrachten Siliziumnitrid-Schicht und anschließendes Ätzen erfolgen. Danach wird in einem Schritt B eine Katalysatorschicht auf der Oberfläche der Schichtanordnung aufgebracht, wobei die Katalysatorschicht einen oder mehrere Teilbereiche aufweist. Dies kann realisiert werden, indem eine Katalysatorschicht, beispielsweise eine 20 nm dicke Nickel-Schicht auf der Oberfläche der Schichtanordnung abgeschieden wird und mittels Elektronenstrahllithographie zu Drähten von im Wesentlichen zueinander parallel verlaufenden Drähten von ungefähr 20 nm Dicke strukturiert wird. In einem nachfolgenden Schritt C wird eine weitere elektrisch isolierende Schicht auf mindestens einen Teil der Oberfläche der Schichtanordnung derart aufgebracht, dass die weitere elektrisch isolierende Schicht mindestens einen der Teilbereiche der Katalysatorschicht mindestens teilweise bedeckt. Dieser Verfahrensschritt kann realisiert werden, indem die Oberfläche der Schichtstruktur zunächst mit einem Photolack bedeckt und dieser dann mittels eines Lithographieverfahrens strukturiert wird. Dann wird beispielsweise eine Siliziumnitrid-Schicht durch Sputtern oder Verdampfen auf der Schichtanordnung abgeschieden. Unter Verwendung eines Lift-Off-Verfahrens kann dann die Siliziumnitrid-Schicht und die darunter liegende Photolack-Schicht von einem Teilbereich der Oberfläche der Schichtanordnung entfernt werden. Dadurch bleibt eine Siliziumnitrid-Schicht nur auf einem gewünschten Oberflächenbereich der Schichtanordnung zurück, erfindungsgemäß nur auf der Oberfläche der Katalysatorschicht. Nun wird in einem nachfolgenden Schritt E die Katalysatorschicht teilweise zurückgeätzt, derart, dass die elektrisch isolierende Schicht und die weitere elektrisch isolierende Schicht seitlich über die Katalysatorschicht hinausstehen, so dass eine Pore erzeugt wird, durch welche die zur Oberfläche des Substrats parallele Aufwachsrichtung der Nanoröhre vorgegeben wird. Dies kann wie bereits oben beschrieben durch nasschemisches Rückätzen von Nickel erfolgen, so dass Poren zurückbleiben. In einem weiteren Verfahrensschritt F wird dann mindestens eine Nanoröhre auf dem freiliegenden Teil der Oberfläche eines Teilbereichs der Katalysatorschicht aufgewachsen, derart, dass die mindestens eine Nanoröhre parallel zur Oberfläche der Schichtanordnung angeordnet wird. Die Herstellung von Nanoröhren kann beispielsweise durch Gasphasenepitaxie erfolgen.

Das erfindungsgemäße Verfahren kann ferner an einer geeigneten Stelle einen weiteren Verfahrensschritt aufweisen, bei dem zwischen mindestens einen Teilbereich der Katalysatorschicht und die an dem mindestens einen Teilbereich der Katalysatorschicht angrenzenden Schichten zumindest teilweise mindestens eine Schicht zur Verhinderung von Diffusion eingebracht wird. Bei der Ankopplung der Nanoröhren-Anordnung an eine herkömmlichen Silizium-Mikroelektronik ist es vorteilhaft, das katalytisch aktive Metall mit Diffusionsbarrieren zu umgeben. Denn das Katalysatormetall kann thermisch in Silizium-Bereiche eines angeschlossenen Schaltkreises eindiffundieren. Als Material für die Schicht zur Verhinderung von Diffusion kann Tantalnitrid verwendet werden.

Die elektrisch isolierende Schicht und/oder die weitere elektrisch isolierende Schicht können aus einem oder einer Kombination der Materialien Siliziumnitrid und Siliziumdioxid hergestellt werden. Es kann jedoch auch jedes andere dafür geeignete Material verwendet werden.

Die Katalysatorschicht wird vorzugsweise aus einem oder einer Kombination der Materialien Nickel, Eisen und Kobalt hergestellt. Alternativ kann jedes andere Material verwendet werden, welches das Wachstum von Nanoröhren katalysiert.

Es ist anzumerken, dass die verfahrensgemäß auf die Anordnung aufgebrachte mindestens eine Nanoröhre vorzugsweise eine Kohlenstoffnanoröhre ist.

Ausführungsbeispiele der Erfindung sind in den Figuren dargestellt und werden im Weiteren näher erläutert.

Es zeigen:
- Figur 1A: eine Draufsicht einer Nanoröhren-Anordnung gemäß einem ersten Ausführungsbeispiel der Erfindung,
- Figur 1B: einen Querschnitt einer Nanoröhren-Anordnung entlang der Schnittlinie I-I' aus Figur 1A gemäß dem ersten Ausführungsbeispiel der Erfindung,
- Figur 1C: eine Draufsicht einer Nanoröhren-Anordnung gemäß einem zweiten Ausführungsbeispiel der Erfindung,
- Figur 1D: einen Querschnitt einer Nanoröhren-Anordnung entlang der Schnittlinie II-II' aus Figur 1C gemäß dem zweiten Ausführungsbeispiel der Erfindung,
- Figur 1E: eine Draufsicht einer Nanoröhren-Anordnung gemäß einem dritten Ausführungsbeispiel der Erfindung,
- Figur 1F: einen Querschnitt einer Nänoröhren-Anordnung entlang der Schnittlinie III-III' aus Figur 1E gemäß dem dritten Ausführungsbeispiel der Erfindung,
- Figur 2: einen Querschnitt einer Nanoröhren-Anordnung gemäß einem Ausführungsbeispiel der erfindungsgemäßen Nanoröhren-Anordnung zur Verwendung als Gassensor,
- Figur 3A: eine Draufsicht (links) und einen Querschnitt entlang der Schnittlinie IVa-IVa'(rechts) einer Schichtanordnung nach einem ersten Verfahrensabschnitt gemäß einem bevorzugten Ausführungsbeispiel des erfindungsgemäßen Verfahrens zum Herstellen einer Nanoröhren-Anordnung,
- Figur 3B: eine Draufsicht und einen Querschnitt entlang der Schnittlinie IVb-IVb' einer Schichtanordnung nach einem zweiten Verfahrensabschnitt gemäß einem bevorzugten Ausführungsbeispiel des erfindungsgemäßen Verfahrens zum Herstellen einer Nanoröhren-Anordnung,
- Figur 3C: eine Draufsicht und einen Querschnitt entlang der Schnittlinie IVc-IVc' einer Schichtanordnung nach einem dritten Verfahrensabschnitt gemäß einem bevorzugten Ausführungsbeispiel des erfindungsgemäßen Verfahrens zum Herstellen einer Nanoröhren-Anordnung,
- Figur 3D: eine Draufsicht und einen Querschnitt entlang der Schnittlinie IVd-IVd' einer Schichtanordnung nach einem vierten Verfahrensabschnitt gemäß einem bevorzugten Ausführungsbeispiel des erfindungsgemäßen Verfahrens zum Herstellen einer Nanoröhren-Anordnung,
- Figur 3E: eine Draufsicht und einen Querschnitt entlang der Schnittlinie IVe-IVe' einer Schichtanordnung nach einem fünften Verfahrensabschnitt gemäß einem bevorzugten Ausführungsbeispiel des erfindungsgemäßen Verfahrens zum Herstellen einer Nanoröhren-Anordnung,
- Figur 3F: eine Draufsicht und einen Querschnitt entlang der Schnittlinie IVf-IVf' einer Schichtanordnung nach einem sechsten Verfahrensabschnitt gemäß einem bevorzugten Ausführungsbeispiel des erfindungsgemäßen Verfahrens zum Herstellen einer Nanoröhren-Anordnung,
- Figur 3G: eine Draufsicht und einen Querschnitt entlang der Schnittlinie IVg-IVg' einer Schichtanordnung nach einem siebten Verfahrensabschnitt gemäß einem bevorzugten Ausführungsbeispiel des erfindungsgemäßen Verfahrens zum Herstellen einer Nanoröhren-Anordnung,
- Figur 4A: eine Draufsicht (links) und einen Querschnitt entlang der Schnittlinie Va-Va' (rechts) einer Schichtanordnung nach einem ersten Verfahrensabschnitt gemäß einem anderen bevorzugten Ausführungsbeispiel des erfindungsgemäßen Verfahrens zum Herstellen einer Nanoröhren-Anordnung,
- Figur 4B: eine Draufsicht und einen Querschnitt entlang der Schnittlinie Vb-Vb' einer Schichtanordnung nach einem zweiten Verfahrensabschnitt gemäß dem anderen bevorzugten Ausführungsbeispiel des erfindungsgemäßen Verfahrens zum Herstellen einer Nanoröhren-Anordnung,
- Figur 4C: eine Draufsicht und einen Querschnitt entlang der Schnittlinie Vc-Vc' einer Schichtanordnung nach einem dritten Verfahrensabschnitt gemäß dem anderen bevorzugten Ausführungsbeispiel des erfindungsgemäßen Verfahrens zum Herstellen einer Nanoröhren-Anordnung,
- Figur 4D: eine Draufsicht und einen Querschnitt entlang der Schnittlinie Vd-Vd' einer Schichtanordnung nach einem vierten Verfahrensabschnitt gemäß dem anderen bevorzugten Ausführungsbeispiel des erfiridungsgemäßen Verfahrens zum Herstellen einer Nanoröhren-Anordnung,
- Figur 4E: eine Draufsicht und einen Querschnitt entlang der Schnittlinie Ve-Ve' einer Schichtanordnung nach einem fünften Verfahrensabschnitt gemäß dem anderen bevorzugten Ausführungsbeispiel des erfindungsgemäßen Verfahrens zum Herstellen einer Nanoröhren-Anordnung,
- Figur 5A: einen Querschnitt einer Schichtanordnung nach einem ersten Verfahrensabschnitt gemäß einem weiteren bevorzugten Ausführungsbeispiel des erfindungsgemäßen Verfahrens zum Herstellen einer Nanoröhren-Anordnung,

- Figur 5B: einen Querschnitt einer Schichtanordnung nach einem zweiten Verfahrensabschnitt gemäß dem weiteren bevorzugten Ausführungsbeispiel des erfindungsgemäßen Verfahrens zum Herstellen einer Nanoröhren-Anordnung,
- Figur 5C: einen Querschnitt einer Schichtanordnung nach einem dritten Verfahrensabschnitt gemäß dem weiteren bevorzugten Ausführungsbeispiel des erfindungsgemäßen Verfahrens zum Herstellen einer Nanoröhren-Anordnung,
- Figur 5D: einen Querschnitt einer Schichtanordnung nach einem vierten Verfahrensabschnitt gemäß dem weiteren bevorzugten Ausführungsbeispiel des erfindungsgemäßen Verfahrens zum Herstellen einer Nanoröhren-Anordnung.

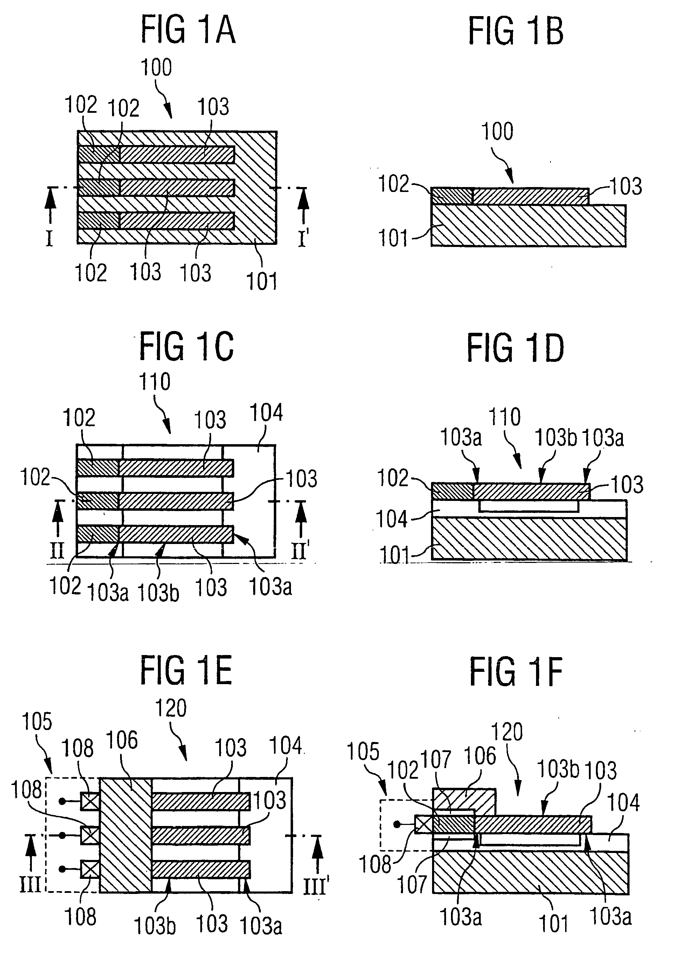

In **Fig. 1A** ist ein erstes Ausführungsbeispiel einer Nanoröhren-Anordnung 100 der Erfindung gezeigt, die aufweist: ein Substrat 101, eine Katalysatorschicht 102, die einen oder mehrere Teilbereiche aufweist, auf der Oberfläche des Substrats 101 und mindestens eine parallel zur Oberfläche des Substrats 101 auf der Oberfläche der Katalysatorschicht 102 angeordnete Nanoröhre 103. Gemäß dem in **Fig. 1A** gezeigten Ausführungsbeispiel weist die Nanoröhren-Anordnung 100 drei Teilbereiche der Katalysatorschicht 102 auf, wobei an jedem der Teilbereiche der Katalysatorschicht 102 jeweils eine Nanoröhre 103 angeordnet ist. In **Fig. 1B** ist eine Querschnittsansicht entlang der Schnittlinie I-I' der Nanoröhren-Anordnung 100 aus **Fig. 1A** gezeigt.

In **Fig. 1C** ist eine Nanoröhren-Anordnung 110 gemäß einem zweiten Ausführungsbeispiel der Erfindung gezeigt. In **Fig. 1D** ist eine Querschnittsansicht entlang der Schnittlinie II-II' der Nanoröhren-Anordnung 110 aus **Fig. 1C** gezeigt. Die Nanoröhren-Anordnung 110 weist gegenüber der Nanoröhren-Anordnung 100 zusätzlich eine elektrisch isolierende Schicht 104 auf, die zwischen dem Substrat 101 und der Katalysatorschicht 102 angeordnet ist. Die elektrisch isolierende Schicht 104 weist eine derartige Topographie auf, hat also eine derartige Oberflächenstruktur, dass die mindestens eine Nanoröhre 103 in ihren Endabschnitten 103a auf der elektrisch isolierenden Schicht 104 aufliegt und in ihrem Mittenabschnitt 103b freiliegt.

Wie insbesondere der in **Fig. 1C** gezeigten Draufsicht der Nanoröhren-Anordnung 110 zu entnehmen ist, sind die Teilbereiche der Katalysatorschicht 102 voneinander elektrisch entkoppelt. Auch sind die Teilbereiche der Nanoröhren 103 voneinander elektrisch entkoppelt.

In **Fig. 1E** ist als drittes Ausführungsbeispiel der Erfindung eine Nanoröhren-Anordnung 120 in Draufsicht gezeigt. In **Fig. 1F** ist eine Querschnittsansicht entlang der Schnittlinie III-III' der Nanoröhren-Anordnung 120 aus **Fig. 1E** gezeigt. Die Nanoröhren-Anordnung 120 weist über die in den Nanoröhren-Anordnungen 100, 110 gezeigten Merkmale hinaus zusätzliche Merkmale auf: so weist die in **Fig. 1E**, **Fig. 1F** gezeigte Nanoröhren-Anordnung 120 eine Schaltkreiseinrichtung 105 auf, mittels derer die Nanoröhren 103 einzeln ansteuerbar und/oder auslesbar sind. Ferner sind gemäß der in **Fig. 1E**, **Fig. 1F** gezeigten Nanoröhren-Anordnung 120 alle drei Teilbereiche der Katalysatorschicht 102 von einer weiteren elektrisch isolierenden Schicht 106 umgeben. Indem die elektrisch isolierende Schicht 104 und die weitere elektrisch isolierende Schicht 106, zwischen denen die Katalysatorschicht 102 angeordnet ist, beidseitig seitlich über die Katalysatorschicht 102 hinausstehen, ist eine Pore ausgebildet, durch welche die zur Oberfläche des Substrats 101 parallele Aufwärtsrichtung der Nanoröhren 103 vorgebbar ist. Darüber hinaus ist, wie in **Fig. 1F** gezeigt, mindestens einer der Teilbereiche der Katalysatorschicht 102 von einer Schicht zur Verhinderung von Diffusion 107 umgeben.

Mittels der Schaltkreiseinrichtung 105 ist die Nanoröhren-Anordnung 120 an eine externe Elektronik ankoppelbar, beispielsweise eine CMOS-Schaltung. Wie in **Fig. 1E** angedeutet, ist jede der drei Nanoröhren 103 über die elektrisch leitfähige Katalysatorschicht 102 mit einer Anschlusselektrode 108 der Schaltkreiseinrichtung 105 gekoppelt.

Indem durch die aus **Fig. 1F** ersichtliche geometrische Anordnung der elektrisch isolierenden Schicht 104, der drei Teilbereiche der Katalysatorschicht 102 und der weiteren elektrisch isolierenden Schicht 106 drei waagerechte Poren erzeugt sind, von denen jede als Schablone für das Wachstum einer der drei Nanoröhren 103 dient, ist eine planare Anordnung von Nanoröhren 103 realisiert. Durch exaktes Vorgeben der Aufwachsstelle und der Aufwachsrichtung sind geometrisch genau strukturierbare Anordnungen von Nanoröhren herstellbar.

Die elektrisch isolierende Schicht 104 und/oder die weitere elektrisch isolierende Schicht 106 sind aus einem oder einer Kombination der Materialien Siliciumnitrid und Siliziumdioxid hergestellt. Gemäß alternativer Ausführungsbeispiele der Erfindung können die elektrisch isolierende Schicht 104 und/oder die weitere elektrisch isolierende Schicht 106 aus einem anderen geeigneten Material hergestellt sein, das die Eigenschaft aufweisen muss, bezüglich dem Aufwachsen von Nanoröhren 103 nicht katalytisch zu wirken. Die Nanoröhren-Anordnung 120 weist eine Schicht zur Verhinderung von Diffusion 107 auf, die vorzugsweise aus Tantalnitrid hergestellt ist. Diese verhindert, dass beispielsweise durch thermische Einflüsse Material der Katalysatorschicht in möglicherweise angrenzende Silizium-Bereiche eines angekoppelten mikroelektronischen Schaltkreises eindiffundiert. Damit wirkt die Schicht zur Verhinderung von Diffusion 107 als Diffusionsbarriere für das katalytisch aktive Material.

Die Katalysatorschicht 102 ist gemäß diesem Ausführungsbeispiel aus einem oder einer Kombination der Materialien Nickel, Eisen und Kobalt hergestellt. Es kann aber auch jedes andere geeignete Material verwendet werden, welches das Aufwachsen von Nanoröhren 103 katalysiert. Sollen, wie in **Fig. 1E** und **Fig. 1F** symbolisiert, die Nanoröhren 103 durch die Katalysatorschicht 102 mit Anschlusselektroden 108 einer externen Schaltkreiseinrichtung 105 gekoppelt werden, so ist für die Katalysatorschicht 102 ein elektrisch leitfähiges Material zu wählen.

Die Nanoröhren 103 in den Nanoröhren-Anordnungen 100, 110, 120 sind Kohlenstoffnanoröhren.

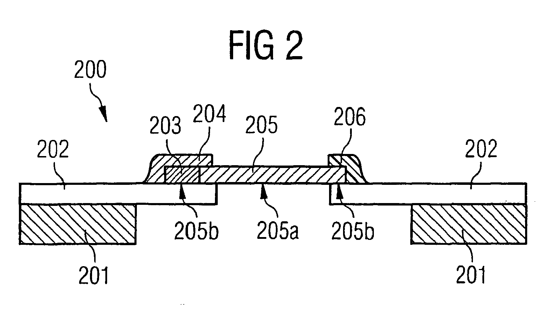

In **Fig. 2** ist als Anwendungsbeispiel für die erfindungsgemäße Nanoröhren-Anordnung ein Gassensor 200 gezeigt. Der Gassensor 200 weist auf ein strukturiertes Substrat 201, eine elektrisch isolierende Schicht 202, eine elektrisch leitfähige Katalysatorschicht 203, eine weitere elektrisch isolierende Schicht 204, eine Kohlenstoffnänoröhre 205 und eine Elektrode 206.

Die Funktionalität des Gassensors 200 beruht auf dem oben beschriebenen physikalischen Effekt, dass der elektrische Widerstand einer Kohlenstoffnanoröhre 205 äußerst empfindlich von der die Kohlenstoffnanoröhre 205 umgebenden Gasatmosphäre abhängt. Wie oben ausgeführt, verringert sich in einer Ammoniakatmosphäre (NH₃) die elektrische Leitfähigkeit von Kohlenstoffnanoröhren um ungefähr drei Zehnerpotenzen. Umgekehrt erhöht sich die elektrische Leitfähigkeit um ungefähr drei Größenordnungen, wenn die Kohlenstoffnanoröhre 205 einer Stickstoffdioxidatmosphäre (NO₂) in einer Konzentration von 200 ppm ("parts per million", 10⁻⁶) ausgesetzt wird.

Wird in einem in **Fig. 2** nicht gezeigten Mittel zum Erfassen des elektrischen Widerstandes der elektrische Widerstand der Kohlenstoffnanoröhre 205 zwischen den elektrisch leitfähigen Schichten 203 und 206 abgenommen, wenn die in ihrem Mittenabschnitt 205a freiliegende Oberfläche der Kohlenstoffnanoröhre 205 einer bestimmten Gasatmosphäre ausgesetzt ist, so ist der Wert des elektrischen Widerstandes der Kohlenstoffnanoröhre 205 ein charakteristisches Maß für die Art bzw. die Konzentration des die Kohlenstoffnanoröhre 205 umgebenden Gases. Das Mittel zum Erfassen des elektrischen Widerstandes ist vorzugsweise in das Substrat 201 integriert. Vorzugsweise ist die zwischen der elektrisch leitfähigen Katalysatorschicht 203 und der elektrisch leitfähigen Elektrode 206 angeordnete Kohlenstoffnanoröhre 205 mit einer in ihrem Mittenabschnitt 205a im Wesentlichen freiliegenden Oberfläche bereitzustellen. Dagegen sind die Endabschnitte 205b der Nanoröhre 205 nicht freiliegend, sondern mit der weiteren elektrisch isolierenden Schicht 204 bzw. mit der elektrisch leitfähigen Elektrode 206 gekoppelt.

Um die Messgenauigkeit des Gassensors 200 zu erhöhen, können mehrere Kohlenstoffnanoröhren 205, von denen alle oder ein Teil einer bestimmten Gasatmosphäre ausgesetzt sind, entweder parallel oder in Reihe oder teilweise parallel und teilweise in Reihe geschaltet werden. Dies kann bezugnehmend auf **Fig. 2** beispielsweise geschehen, indem die einzelnen Kohlenstoffnanoröhren 205 zueinander im Wesentlichen parallel in einer Ebene senkrecht zu der Zeichenebene angeordnet sind.

Der in **Fig. 2** gezeigte Gassensor 200 kann beispielsweise wie folgt beschrieben betrieben werden. Die Anordnung 200 wird mit einer zu detektierenden Gasatmosphäre in Wirkkontakt gebracht. Zwischen den elektrisch leitfähigen Kontaktierungen 203, 206 der Kohlenstoffnanoröhren 205 ist durch das Mittel zum Erfassen des elektrischen Widerstandes der elektrische Widerstand der Kohlenstoffnanoröhre 205 ermittelbar, wobei der Wert des elektrischen Widerstandes der Kohlenstoffnanoröhre 205 charakteristisch für die Konzentration bzw. die Art des umgebenden Gases ist. Indem die empfindliche Kohlenstoffnanoröhre 205 auf der robusten elektrisch isolierenden Schicht 202 bzw. auf dem robusten strukturierten Substrats 201 aufgebracht ist, ist der Gassensor 200 ausreichend robust ausgestaltet, um für den praktischen Einsatz im Labor geeignet zu sein.

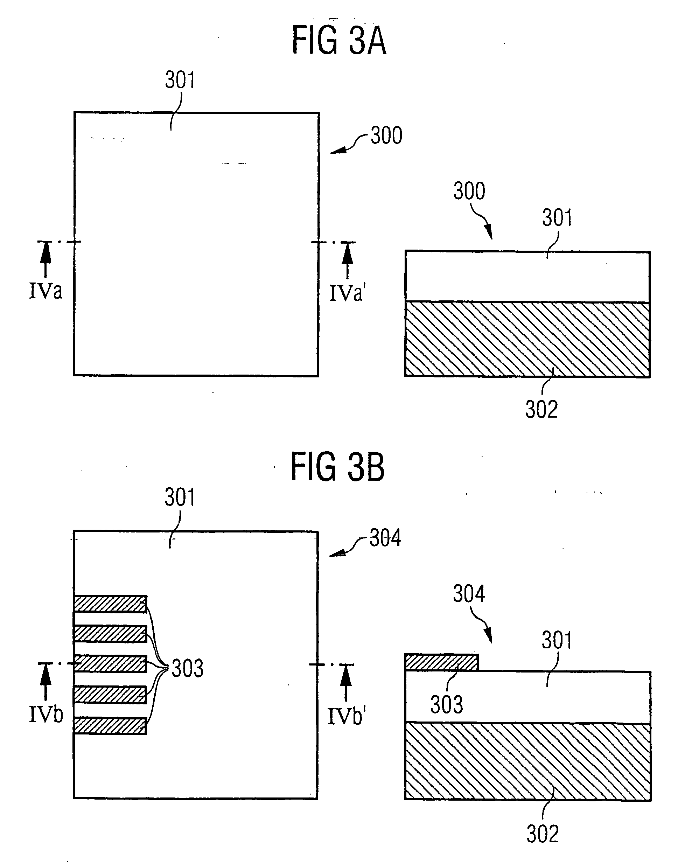

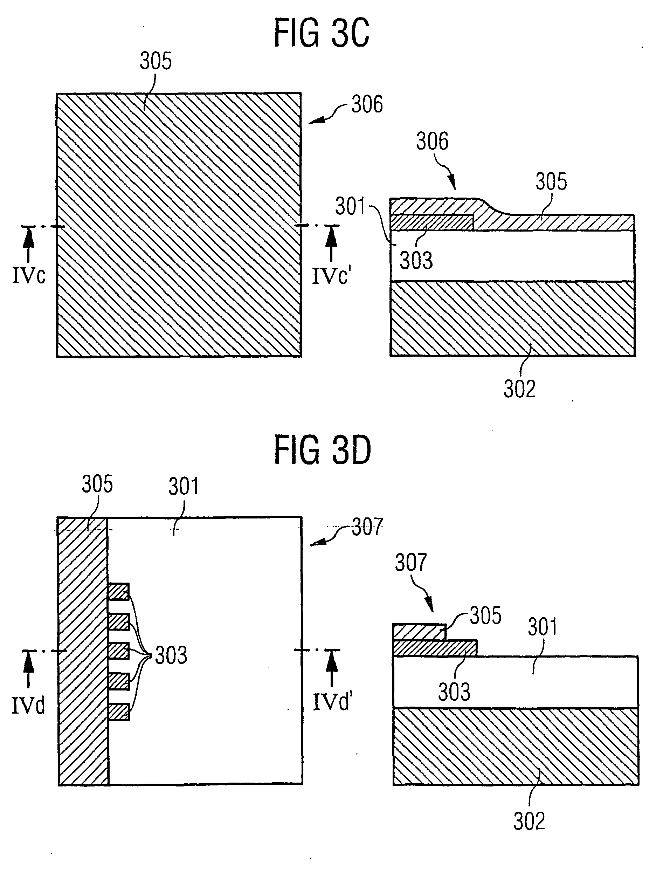

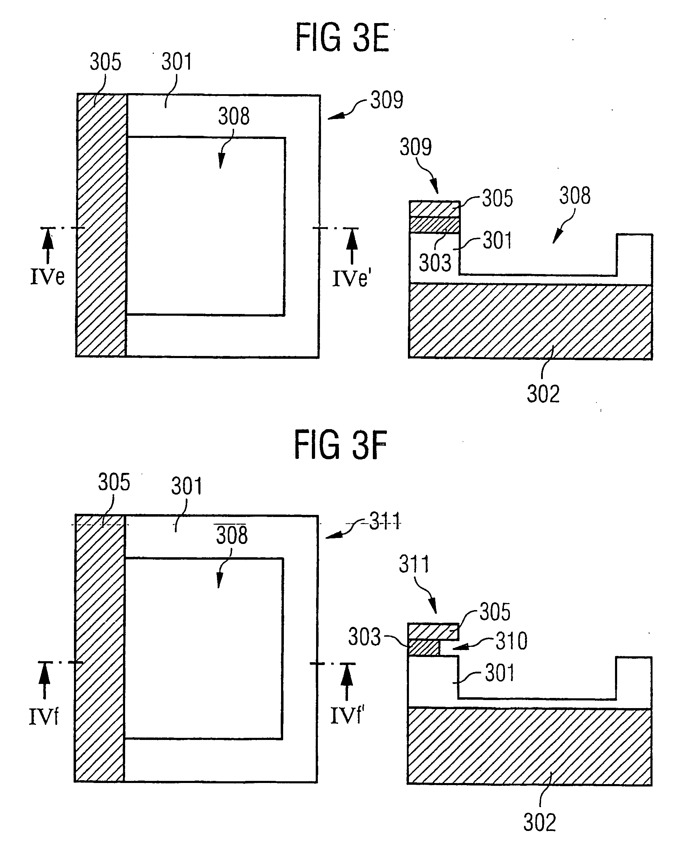

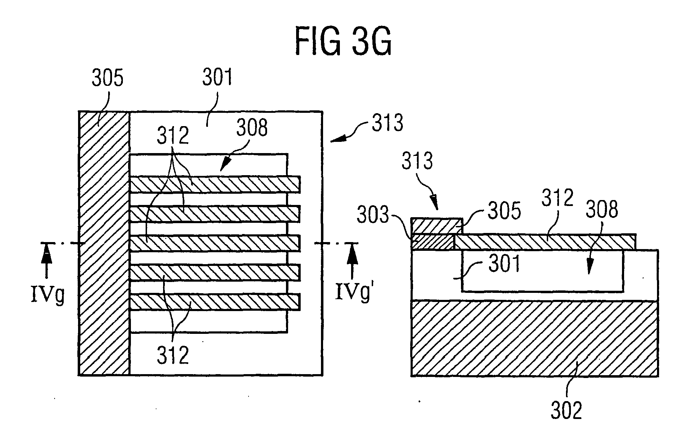

Im Weiteren wird bezugnehmend auf **Fig. 3A, Fig. 3B****,** **Fig. 3C, Fig. 3D****,** **Fig. 3E, Fig. 3F** und **Fig. 3G** ein erstes bevorzugtes Ausführungsbeispiel des erfindungsgemäßen Verfahrens zum Herstellen einer Nanoröhren-Anordnung beschrieben, das die Verfahrensschritte A, B, C, D, E, F aufweist. Gemäß dem beschriebenen Ausführungsbeispiel sind diese Schritte in der Reihenfolge A, B, C, D, E, F durchzuführen. In **Fig. 3A, Fig. 3B****,** **Fig. 3C, Fig. 3D****,** **Fig. 3E, Fig. 3F** bzw. **Fig. 3G** sind jeweils auf der linken Seite eine Draufsicht und auf der rechten Seite eine zugehörige Querschnittsansicht entlang der Schnittlinien IVa-IVa', IVb-IVb', IVc-IVc', IVd-IVd', IVe-IVe', IVf-IVf' bzw. IVg-IVg' derjenigen Schichtanordnung gezeigt, wie sie jeweils nach Durchführung der einzelnen Verfahrensschritte erhalten wird.

In Schritt A wird eine Schichtanordnung 300 durch Aufbringen einer elektrisch isolierenden Schicht 301 auf einem Substrat 302 ausgebildet.

Die nach Durchführen von Schritt A erhaltene Schichtstruktur 300 ist in **Fig.3A** gezeigt. Vorzugsweise ist das Substrat 302 ein Silizium-Wafer, alternativ kann das Substrat 302 auch ein Glas-Substrat sein. Die auf dem Substrat 302 abgeschiedene elektrisch isolierende Schicht 301 kann beispielsweise eine Siliziumnitrid-Schicht sein oder kann alternativ eine Siliziumdioxid-Schicht sein.

In Schritt B wird eine Katalysatorschicht 303 auf der Oberfläche der Schichtanordnung 300 aufgebracht, wobei die Katalysatorschicht 303 einen oder mehrere Teilbereiche aufweist.

Nachdem Schritt B ausgeführt ist, wird eine Schichtanordnung 304 erhalten (vgl. **Fig. 3B**). Gemäß der in **Fig. 3B** gezeigten Schichtanordnung 304 weist die Katalysatorschicht 303 fünf Teilbereiche auf. Schritt B wird realisiert, indem in einem ersten Teilschritt eine Katalysatorschicht 303 auf die Oberfläche der Schichtanordnung 300 abgeschieden wird. Es wird eine 20 nm dicke Nickel-Schicht auf der Oberfläche der Schichtstruktur 300 abgeschieden. Diese auf der gesamten Oberfläche der Schichtstruktur 300 abgesetzte Nickel-Schicht wird dann in einem zweiten Teilschritt unter Verwendung eines geeigneten Lithographieverfahrens, beispielsweise mittels Elektronenstrahllithographie, strukturiert. Vorzugsweise wird die abgeschiedene Nickel-Schicht derart strukturiert, dass Drähte von 20 nm Durchmesser zurückbleiben.

In einem Schritt C wird sodann eine weitere elektrisch isolierende Schicht 305 auf mindestens einen Teil der Oberfläche der Schichtanordnung 304 aufgebracht, derart, dass die weitere elektrisch isolierende Schicht 305 mindestens einen der Teilbereiche der Katalysatorschicht 303 mindestens teilweise bedeckt.

Die Teilschritte des Schrittes C sind anhand **Fig. 3C** und **Fig. 3D** nachzuvollziehen. In einem ersten Teilschritt wird die weitere elektrisch isolierende Schicht 305 auf die Oberfläche der Schichtanordnung 304 aufgebracht. Beispielsweise kann dies erfolgen, indem eine Siliziumdioxid-Schicht auf der Oberfläche der Schichtanordnung 304 aufgebracht wird. Dadurch wird eine Schichtanordnung 306 erhalten, wie sie in **Fig. 3C** gezeigt ist. In einem zweiten Teilschritt wird dann die aufgebrachte weitere elektrisch isolierende Schicht 305 unter Verwenden eines geeigneten Lithographie- bzw. Ätzverfahrens strukturiert. Dadurch wird die in **Fig. 3D** gezeigte Schichtanordnung 307 erhalten, bei der ein Teilbereich der weiteren elektrisch isolierenden Schicht 305 die Katalysatorschicht 303 teilweise bedeckt.

In einem nachfolgenden Schritt D wird ein Graben 308 in einen Oberflächenbereich der Schichtanordnung 307 geätzt.

Daraus resultiert die in **Fig. 3E** dargestellte Schichtanordnung 309. Verfahrensschritt D wird mittels eines geeigneten Photolithographieverfahrens realisiert.

In einem nächsten Verfahrensschritt E wird die Katalysatorschicht 303 teilweise zurückgeätzt, derart, dass die elektrisch isolierende Schicht 301 und die weitere elektrisch isolierende Schicht 305 seitlich über die Katalysatorschicht 303 hinausstehen, so dass eine Pore 310 erzeugt wird, durch welche die zur Oberfläche des Substrats 302 parallele Aufwachsrichtung der Nanoröhre vorgegeben wird.

Nach diesem Verfahrensschritt wird die Schichtanordnung 311 erhalten, die in **Fig. 3F** dargestellt ist. Indem durch das beidseitig seitliche Überstehen der elektrisch isolierenden Schicht 301 und der weiteren elektrisch isolierenden Schicht 305 über die Katalysatorschicht 303 hinaus eine Pore 310 ausgebildet wird, wird die Art und Weise des nachfolgenden Aufwachsens der Nanoröhre (siehe Schritt F, unten) weitgehend festgelegt. Da Nanoröhren bevorzugt auf katalytisch aktivem Material, d.h. auf freiliegenden Oberflächenbereichen der Katalysatorschicht 303, aufwachsen, ist die "Keimstelle" des Nanoröhren-Wachstums festgelegt. Durch das seitliche Überstehen der elektrisch isolierenden Schicht 301 und der weiteren elektrisch isolierenden Schicht 305 über die Katalysatorschicht 303 ist ferner die Aufwachsrichtung definiert. Anschaulich ist für das Aufwachsen der Nanoröhre eine Führung bzw. eine Schablone bereitgestellt. Dadurch lassen sich Durchmesser, Wachsrichtung und Anordnung der Nanoröhren durch die Porengeometrie steuern. Verfahrenstechnisch kann das Rückätzen der Katalysatorschicht 303 durch nasschemisches Rückätzen realisiert werden. So sind aus dem Stand der Technik Verfahren bekannt, mittels derer beispielsweise aus Nickel bestehende Katalysatorschichten 303 nasschemisch zurückgeätzt werden können.

In einem nachfolgenden Schritt F wird mindestens eine Nanoröhre 312 auf einem freiliegenden Teil der Oberfläche eines Teilbereichs der Katalysatorschicht 303 aufgewachsen, derart, dass die mindestens eine Nanoröhre 312 parallel zur Oberfläche der Schichtanordnung 311 angeordnet wird.

Nachdem Schritt F ausgeführt ist, wird die Schichtanordnung 313 erhalten, die in **Fig. 3G** dargestellt ist. Die Herstellung der Nanoröhren 312 erfolgt beispielsweise mittels Gasphasenepitaxie. Wie weiter oben ausgeführt, sind durch die Poren 310 sowie durch die Dicke der Katalysatorschicht 303 Aufwachsrichtung und Durchmesser der Nanoröhren 312 vorgebbar.

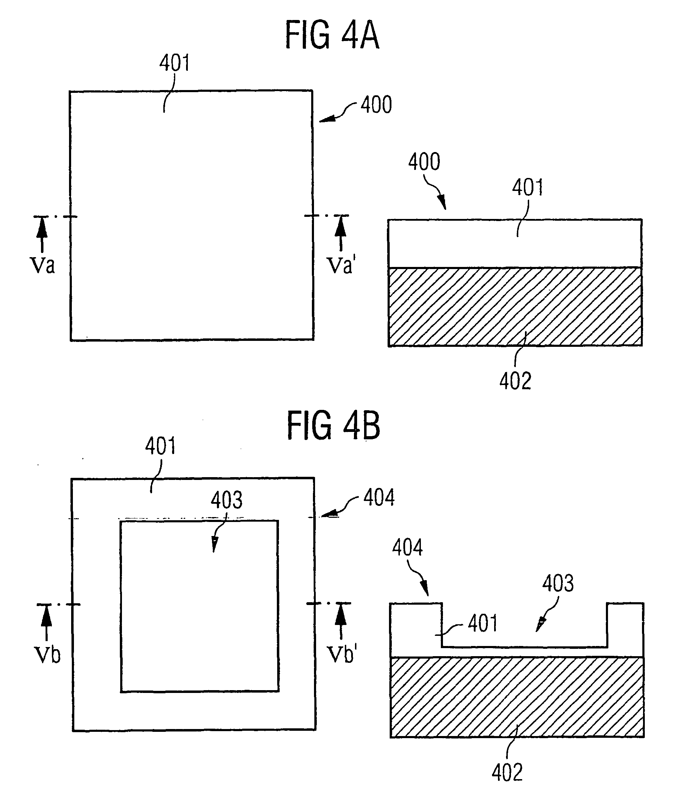

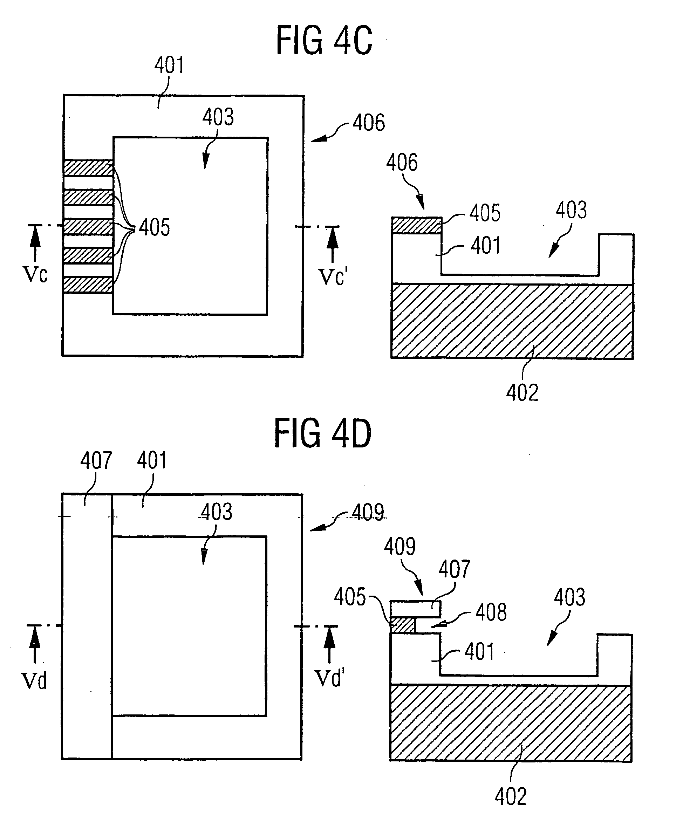

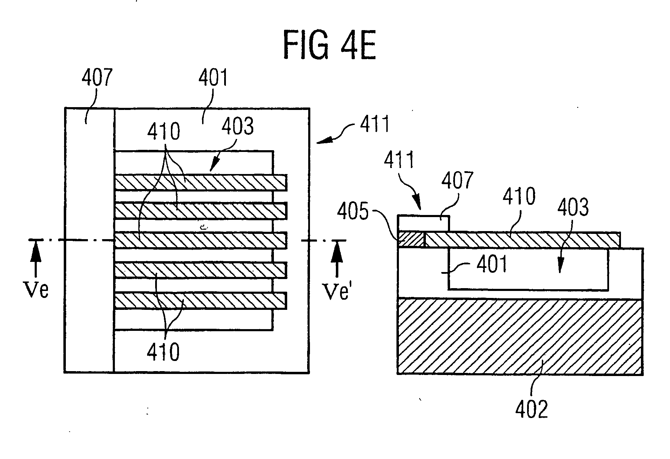

Im Weiteren wird ein zweites Ausführungsbeispiel des erfindungsgemäßen Verfahrens zum Herstellen einer Nanoröhren-Anordnung anhand der **Fig. 4A, Fig. 4B****,** **Fig. 4C, Fig. 4D****,** **Fig. 4E** erläutert. Dieses unterscheidet sich im Wesentlichen von dem zuvor dargestellten Ausführungsbeispiel in der Reihenfolge, in der die Schritte A bis F durchgeführt werden. In **Fig. 4A, Fig. 4B****,** **Fig. 4C, Fig. 4D** bzw. **Fig. 4E** sind jeweils auf der linken Seite eine Draufsicht und auf der rechten Seite eine zugehörige Querschnittsansicht entlang der Schnittlinien Va-Va', Vb-Vb', Vc-Vc', Vd-Vd' bzw. Ve-Ve' derjenigen Schichtanordnung gezeigt, wie sie jeweils nach Durchführung einzelner Verfahrensschritte erhalten wird.

Das zweite Ausführungsbeispiel des erfindungsgemäßen Verfahrens zum Herstellen einer Nanoröhren-Anordnung weist die folgenden Schritte auf:
In Schritt A wird eine Schichtanordnung 400 durch Aufbringen einer elektrisch isolierenden Schicht 401 auf einem Substrat 402 ausgebildet.

Nach Schritt A wird die in **Fig. 4A** gezeigte Schichtstruktur 400 erhalten. Die elektrisch isolierende Schicht 401 ist eine Siliziumnitrid-Schicht oder alternativ eine Siliziumdioxid-Schicht, und das Substrat 402 ist ein Silizium-Wafer oder alternativ ein Glas-Substrat.

In einem Schritt A nachfolgenden Schritt D wird ein Graben 403 in einen Oberflächenbereich der Schichtanordnung 400 geätzt.

Das Einbringen des Grabens 403 in die elektrisch isolierende Schicht 401 auf der Oberfläche des Substrats 402 wird durch Photostrukturieren und anschließendes Ätzen der Oberfläche der Schichtstruktur 400 realisiert. Nach Durchführung des auf den Schritt A folgenden Schrittes D wird die in **Fig. 4B** gezeigte Schichtanordnung 404 erhalten.

In einem auf den oben beschriebenen Schritt D nachfolgenden Schritt B wird eine Katalysatorschicht 405 auf der Oberfläche der Schichtanordnung 404 aufgebracht, wobei die Katalysatorschicht 405 einen oder mehrere Teilbereiche aufweist.

Gemäß der in **Fig. 4C** dargestellten Schichtanordnung 406, die nach Durchführen des Schrittes B erhalten wird, weist die Katalysatorschicht 405 fünf Teilbereiche auf. Der als Schritt B bezeichnete Verfahrensschritt weist bei der praktischen Realisierung üblicherweise mehrere Teilschritte auf. In einem ersten Teilschritt wird auf der gesamten Oberfläche der Schichtstruktur 404 eine Katalysatorschicht 405 aufgebracht. Beispielsweise wird eine ungefähr 20 nm dicke Nickel-Schicht auf der Oberfläche der Schichtstruktur 404 abgeschieden. In einem zweiten Teilschritt des Schrittes B wird die Katalysatorschicht 405 mittels eines geeigneten Lithographieverfahrens, beispielsweise mittels Elektronenstrahllithographie, derart strukturiert, dass auf der Oberfläche der Schichtanordnung 404 ein oder mehrere Teilbereiche zurückbleiben. Bezugnehmend auf **Fig. 4C** bleiben nach diesem Teilschritt fünf Teilbereiche der Katalysatorschicht 405 auf der Oberfläche der Schichtstruktur zurück. Vorzugsweise wird die Katalysatorschicht 405 zu Drähten von ungefähr 20 nm Breite strukturiert. Wie in der Querschnittsansicht von **Fig. 4C** gezeigt, bleibt nach dem Photostrukturieren Material der Katalysatorschicht 405 nur in einem links des Grabens 403 angeordneten Bereich auf der Oberfläche der Schichtstruktur 406 zurück.

In einem nachfolgenden Schritt C wird eine weitere elektrisch isolierende Schicht 407 auf mindestens einen Teil der Oberfläche der Schichtanordnung 406 aufgebracht, derart, dass die weitere elektrisch isolierende Schicht 407 mindestens einen der Teilbereiche der Katalysatorschicht 405 mindestens teilweise bedeckt.

Auch der als Schritt C bezeichnete Verfahrensschritt weist mehrere Teilschritte auf. In einem ersten Teilschritt wird auf die Oberfläche der Schichtstruktur 406 eine Photolack-Schicht abgesetzt. In einem zweiten Teilschritt wird ein Lithographieverfahren mit einer geeigneten Maske verwendet, um die Oberfläche der mit dem Photolack bedeckten Schichtanordnung 406 zu strukturieren. In einem weiteren Teilschritt wird eine weitere elektrisch isolierende Schicht 407, beispielsweise aus Siliziumnitrid-Material oder aus Siliziumdioxid-Material, mittels eines geeigneten halbleitertechnologischen Verfahrens, beispielsweise durch Sputtern oder Verdampfen, auf der Oberfläche der mit Photolack versehenen und photostrukturierten Schichtanordnung 406 abgesetzt. In einem weiteren Teilschritt wird unter Verwendung eines Lift-Off-Verfahrens die aus der Photolack-Schicht und der elektrisch isolierenden Schicht 407 zusammengesetzte Doppelschicht von einem Teilbereich der Oberfläche der Schichtanordnung entfernt. Zurück bleibt eine Schichtanordnung, die sich von der in **Fig. 4C** dargestellten Schichtanordnung 406 im Wesentlichen dadurch unterscheidet, dass die weitere elektrisch isolierende Schicht 407 in einem gemäß der Querschnittsansicht der Schichtanordnung links der linken Grenze des Grabens 403 befindlichen Oberflächenbereich der Schichtanordnung zurückbleibt.

In einem nachfolgenden Verfahrensschritt E wird die Katalysatorschicht 405 teilweise zurückgeätzt, derart, dass die elektrisch isolierende Schicht 401 und die weitere elektrisch isolierende Schicht 407 seitlich über die Katalysatorschicht 405 hinausstehen, so dass eine Pore 408 erzeugt wird, durch welche die zur Oberfläche des Substrats 402 parallele Aufwachsrichtung der Nanoröhre vorgegeben wird.

Nach Durchführen des Verfahrensschrittes E wird die in **Fig. 4D** gezeigte Schichtanordnung 409 erhalten. Schritt E kann dadurch realisiert werden, dass die Katalysatorschicht 405 nasschemisch zurückgeätzt wird und dadurch Poren 408 ausgebildet werden. Beispielsweise wird eine aus Nickel hergestellte Katalysatorschicht 405 mittels eines nasschemischen Ätzverfahrens zurückgeätzt. Wie oben ausgeführt, ist das Ausbilden von Poren 408 zum Definieren der Aufwachsrichtung einer Nanoröhre, des Durchmessers einer Nanoröhre und der Erzeugung einer geordneten Struktur von Nanoröhren essentiell.

In einem nachfolgenden Verfahrensschritt F wird mindestens eine Nanoröhre 410 auf einem freiliegenden Teil der Oberfläche eines Teilbereichs der Katalysatorschicht 405 aufgewachsen, derart, dass die mindestens eine Nanoröhre 410 parallel zur Oberfläche der Schichtanordnung 409 angeordnet ist.

Nach Durchführung des Verfahrensschritts F wird die in **Fig. 4E** gezeigte Schichtanordnung 411 erhalten. Die Herstellung von Nanoröhren 410 kann beispielsweise mittels des Verfahrens der Gasphasenepitaxie erfolgen, welches Verfahren aus dem Stand der Technik bekannt ist.

Ferner kann das beschriebene Verfahren zur Herstellung einer Nanoröhren-Anordnung den weiteren Schritt aufweisen, dass zwischen mindestens einem Teilbereich der Katalysatorschicht 405 und die daran angrenzenden Schichten 401, 407 eine Schicht zur Verhinderung von Diffusion (nicht gezeigt in den Figuren) eingebracht wird. Dadurch kann verhindert werden, dass das Material der Katalysatorschicht 405 beispielsweise infolge thermischer Einflüsse in siliziumaufweisende Bereiche eines möglicherweise angeschlossenen externen Schaltkreises (nicht gezeigt in den Figuren) eindiffundiert. Die Schicht zur Verhinderung von Diffusion (in **Fig. 1F** mit der Bezugsziffer 107 versehen) wird vorzugsweise aus Tantalnitrid hergestellt.

Die elektrisch isolierende Schicht 401 und/oder die weitere elektrisch isolierende Schicht 407 werden voneinander unabhängig aus einem oder einer Kombination der Materialien Siliziumnitrid und Siliziumdioxid hergestellt.

Die Katalysatorschicht 405 wird vorzugsweise aus einem oder einer Kombination der Materialien Nickel, Eisen und Kobalt hergestellt. Alternativ kann für die Herstellung der Katalysatorschicht 405 jedes andere katalytisch aktive Material verwendet werden.

Die auf die Schichtanordnung 409 aufzuwachsenden Nanoröhren 410 sind gemäß diesem Ausführungsbeispiel Kohlenstoffnanoröhren.

Im Weiteren wird ein weiteres Ausführungsbeispiel des erfindungsgemäßen Verfahrens zum Herstellen einer Nanoröhren-Anordnung beschrieben, das auf die Verwendung der verfahrensgemäß hergestellten Nanoröhren-Anordnung als Gassensor zugeschnitten ist.

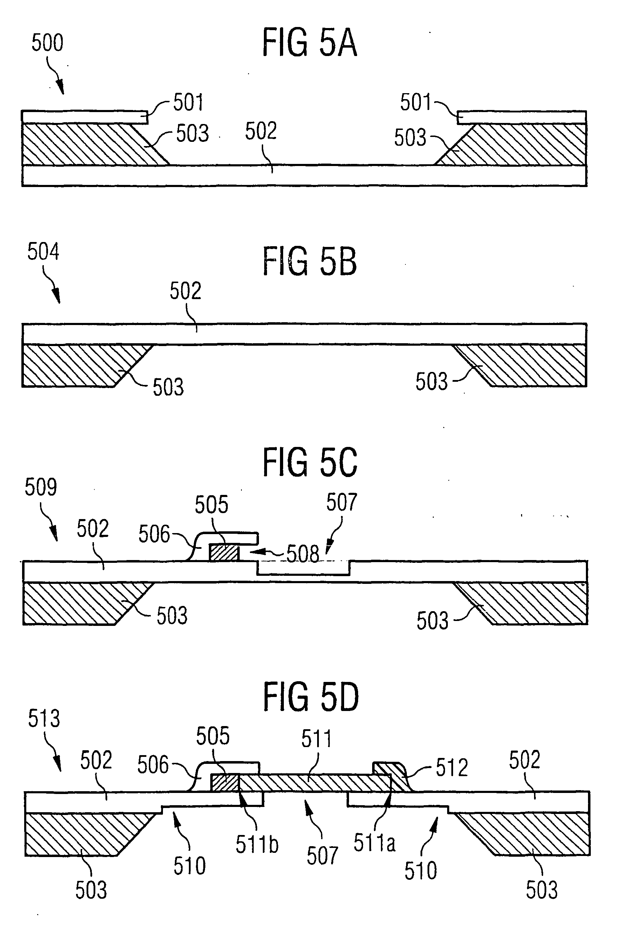

Das im Weiteren beschriebene Verfahren zur Herstellung des Gassensors wird bezugnehmend auf **Fig. 5A, Fig. 5B, Fig. 5C, Fig. 5D** beschrieben.

In einem ersten Schritt A wird eine Schichtanordnung 504 durch Aufbringen einer elektrisch isolierenden Schicht 501, 502 auf einem Substrat 503 ausgebildet.

Nach Ausführen des Schrittes A wird die Schichtanordnung 504 erhalten, die in **Fig. 5B** dargestellt ist. Schritt A weist mehrere Teilschritte auf. In einem ersten Teilschritt wird auf beiden Hauptseiten eines Substrats 503 jeweils eine elektrisch isolierende Schicht aufgebracht. In **Fig. 5A** sind diese beiden Schichten als erste elektrisch isolierende Schicht 501 und als zweite elektrisch isolierende Schicht 502 bezeichnet. Das Substrat 503 ist vorzugsweise ein Silizium-Wafer, die erste elektrisch isolierende Schicht 501 und/oder die zweite elektrisch isolierende Schicht 502 werden vorzugsweise aus Siliziumnitrid-Material oder alternativ aus Siliziumdioxid-Material hergestellt. Es ist auch möglich, dass die erste isolierende Schicht 501 und die zweite elektrisch isolierende Schicht 502 aus verschiedenen Materialien hergestellt werden. Um das Substrat 502 zu strukturieren, wird in einem nächsten Teilschritt zunächst die auf einer Hauptseite des Substrats 503 aufgebrachte elektrisch isolierende Schicht 501 mittels eines geeigneten halbleitertechnologischen Verfahrens derart strukturiert, dass in einem Mittenbereich der Schichtanordnung 500 ein Oberflächenbereich des Substrates 503 freigelegt wird. Anschaulich wird in die erste elektrisch isolierende Schicht 501 ein Loch, beispielsweise im Wesentlichen kreis- oder rechteckförmig, geätzt. In einem nächsten Teilschritt wird ein geeignetes Ätzverfahren auf die Schichtstruktur angewendet um das Material des Substrats 503 von dem Mittenbereich der Anordnung zu entfernen, in dem zuvor durch das Ätzverfahren ein Teil der Oberfläche des Substrates freigelegt wurde. Hierzu ist ein Ätzverfahren anzuwenden, bei dem die verwendeten Ätzchemikalien so auszuwählen sind, dass diese das Material des Substrats 503 ätzen, wohingegen die Materialien der ersten elektrisch isolierenden Schicht 501 sowie der zweiten elektrisch isolierenden Schicht 502 durch die Ätzchemikalie nicht angegriffen werden. Nach Durchführen der beschriebenen Teilschritte wird die in **Fig. 5A** gezeigte Schichtanordnung 500 erhalten. In einem nächsten Teilschritt wird die erste elektrisch isolierende Schicht 501 von der Oberfläche der Schichtstruktur 500 entfernt, wodurch die in **Fig. 5B** gezeigte Schichtstruktur 504 erhalten wird. Dies kann beispielsweise mittels eines geeigneten Ätzverfahrens realisiert werden.

Die im Folgenden beschriebenen Verfahrensschritte werden vorwiegend auf derjenigen Hauptseite der zweiten elektrisch isolierenden Schicht 502 vorgenommen, die dem Substrat 503 abgewandt ist. Um dies zeichnerisch kenntlich zu machen, ist in **Fig. 5B** die Schichtanordnung 504 gegenüber der Schichtanordnung 500 aus **Fig. 5A** um einen Winkel von 180° gedreht.

In einem Schritt B wird eine Katalysatorschicht 505 auf der Oberfläche der Schichtanordnung 504 aufgebracht, wobei die Katalysatorschicht 505 einen oder mehrere Teilbereiche aufweist.

Die Schichtstruktur, wie sie nach Durchführung des Schrittes B erhalten wird, ist in den Figuren nicht gezeigt. Der Verfahrensschritt B wird realisiert, indem zunächst eine die Oberfläche der Schichtstruktur 504 vollständig bedeckende Katalysatorschicht 505 aufgebracht wird und diese Katalysatorschicht 505 dann mittels eines geeigneten halbleitertechnologischen Verfahrens, beispielsweise mittels des Elektronenstrahllithographie-Verfahrens, strukturiert wird. Beispielsweise kann eine Eisen-Schicht oder eine Kobalt-Schicht oder eine Nickel-Schicht oder eine Schicht aus einem beliebigen anderen, das Wachstum von Nanoröhren katalysierenden Material aufgebracht werden, und unter Verwendung des Elektronenstrahllithographie-Verfahrens zu Drähten von beispielsweise 20 nm Dicke strukturiert werden. Die einzelnen Teilbereiche der Katalysatorschicht 505 sind aus den Querschnittansichten von **Fig. 5C, Fig. 5D** nicht ersichtlich.

In einem nachfolgenden Verfahrensschritt C wird eine weitere elektrisch isolierende Schicht 506 auf mindestens einen Teil der Oberfläche der Schichtanordnung aufgebracht, derart, dass die weitere elektrisch isolierende Schicht 506 mindestens einen der Teilbereiche der Katalysatorschicht 505 mindestens teilweise bedeckt.

Der Verfahrensschritt C wird realisiert, indem zunächst eine die gesamte Oberfläche der Schichtanordnung bedeckende weitere elektrisch isolierende Schicht 506 aufgebracht wird und diese mittels eines geeigneten halbleitertechnologischen Verfahrens strukturiert wird. Beispielsweise ist die weitere elektrisch isolierende Schicht 506 eine Siliziumdioxid-Schicht, alternativ kann die weitere elektrisch isolierende Schicht 506 eine Siliziumnitrid-Schicht sein, die dann beispielsweise mittels eines Photolithographie-Verfahrens strukturiert wird.

In dem nächsten Verfahrensschritt D wird ein Graben 507 in einen Oberflächenbereich der Schichtanordnung geätzt.

Dieser Schritt wird praktisch umgesetzt, indem die Oberfläche der Schichtanordnung beispielsweise unter Verwendung eines Photolithographieverfahrens strukturiert wird.

In einem Verfahrensschritt E wird die Katalysatorschicht 505 teilweise zurückgeätzt, derart, dass die elektrisch isolierende Schicht 502 und die weitere elektrisch isolierende Schicht 506 seitlich über die Katalysatorschicht 505 hinausstehen, so dass eine Pore 508 erzeugt wird, durch welche die zur Oberfläche des Substrats 503 parallele Aufwachsrichtung der Nanoröhre vorgegeben wird.

Dadurch wird die Schichtstruktur 509 erhalten, die in Fig. 5C gezeigt ist. Der Verfahrensschritt E kann realisiert werden, indem die Katalysatorschicht 505 nasschemisch zurückgeätzt wird, um so eine Pore 508 zu erzeugen.

Um die verfahrensgemäß hergestellte Nanoröhren-Anordnung als Gassensor verwenden zu können (verwendungsgemäß soll ein möglichst großer Teil der Oberfläche der Nanoröhre freiliegen), weist das beschriebene Ausführungsbeispiel des erfindungsgemäßen Herstellungsverfahrens einige Besonderheiten auf. Da die in einem weiteren Verfahrensschritt aufzubringende Nanoröhre mit einer umgebenden Gasatmosphäre in Wirkkontakt geraten muss, so dass sich infolge des Wirkkontakts der elektrische Widerstand der Nanoröhre in für das umgebende Gas charakteristischer Weise verändert, muss bei dem hergestellten Gassensor die mindestens eine Nanoröhre in einem möglichst großen Oberflächenbereich freiliegen, d.h. dem umgebenden Gas ausgesetzt sein. Um dies zu realisieren, wird in einem Zwischenverfahrensschritt E1 die zweite elektrisch isolierende Schicht 502 auf ihrer dem Substrat 503 zugewandten Hauptseite der zweiten elektrisch isolierenden Schicht in einem Mittenbereich teilweise zurückgeätzt. Dadurch wird die in Fig. 5D veranschaulichte Nut 510 ausgebildet, die in die zweite elektrisch isolierende Schicht 502 ausreichend tief eingebracht wird, um gemeinsam mit dem Graben 507 ein Durchgangsloch durch die zweite elektrisch isolierende Schicht 502 zu erzeugen.

In einem nachfolgenden Verfahrensschritt F wird dann mindestens eine Nanoröhre 511 auf einem freiliegenden Teil der Oberfläche eines Teilbereichs der Katalysatorschicht 505 aufgewachsen, derart, dass die mindestens eine Nanoröhre 511 parallel zur Oberfläche der Schichtanordnung angeordnet wird.

Die Herstellung der Nanoröhren 511 erfolgt beispielsweise durch Verwendung des Gasphasenepitaxie-Verfahrens. Indem die zweite elektrisch isolierende Schicht 502 (gemäß **Fig. 5D** von unten her) und die weitere elektrisch isolierende Schicht 506 (gemäß **Fig. 5D** von oben her) über die Katalysatorschicht 505 beidseitig seitlich hinausstehen, wird eine Pore 508 ausgebildet. Das Wachstum der Nanoröhren 511 kann nur von der Oberfläche einer katalytisch aktiven Schicht ausgehen. Daher kann das Wachstum der mindestens einen Nanoröhre 511 nur aus der Pore 508 heraus, ausgehend von der freiliegenden Oberfläche der Katalysatorschicht 505, erfolgen. Da die Aufwachsrichtung durch die kanalartige Schablone, die durch die zweite elektrisch isolierende Schicht 502 und die weitere elektrisch isolierende Schicht 506 ausgebildet wird, vorgegeben werden kann, ist die Aufwachsrichtung der Nanoröhre 511 festlegbar. Daher ist es erfindungsgemäß ermöglicht, dass die in **Fig. 5D** gezeigte Nanoröhre 511 nur in horizontaler Richtung aufwachsen kann, d.h. in einer Richtung parallel zur Oberfläche des Substrats 503. Durch die Dicke der Katalysatorschicht 505 ist der Durchmesser der Nanoröhre 511 vorgebbar. Dadurch sind durch geeignete Wahl der Dicke der Katalysatorschicht 505 einzelne Nanoröhren 511 aufwachsbar.

Um die Nanoröhren-Anordnung der Erfindung als Gassensor zu verwenden, ist ein weiterer Zusatzschritt erforderlich. Denn die Verwendung der Nanoröhren-Anordnung als Gassensor setzt voraus, dass eine physikalische Größe der Nanoröhre, die auf eine umgebende Gasatmosphäre sensitiv ist, erfasst wird. Wie oben beschrieben, ist insbesondere der elektrische Widerstand einer Nanoröhre ein empfindliches Maß für die Art und die Konzentration eines umgebenden Gases. Daher muss der elektrische Widerstand der Nanoröhre 511 erfasst werden, und hierfür ist die als Gassensor zu verwendende Nanoröhren-Anordnung an ein Mittel zum Erfassen des elektrischen Widerstandes (nicht gezeigt in den Figuren) anzukoppeln. Hierzu muss die mindestens eine Nanoröhre 511 beidseitig elektrisch kontaktiert werden, wobei über diese elektrischen Kontaktierungen dann eine Kopplung an das Mittel zum Erfassen des elektrischen Widerstandes erfolgen kann. Daher muss in einem weiteren Zusatzschritt der freiliegende Endabschnitt 511a der Nanoröhre 511, der nicht mit der Katalysatorschicht 505 gekoppelt ist, elektrisch kontaktiert werden. Hierzu wird eine elektrisch leitfähige elektrische Kontaktierung 512 auf die Schichtstruktur aufgebracht, um mit dem freiliegenden Endabschnitt 511a der Nanoröhre 511 gekoppelt zu werden. Die resultierende Schichtstruktur 513 ist in **Fig. 5D** gezeigt. Nicht in **Fig. 5D** gezeigt ist die elektrische Kontaktierung des anderen Endabschnittes 511b der Nanoröhre 511, die mit der Katalysatorschicht 505 gekoppelt ist. Auch dieser andere Endabschnitt 511b der Nanoröhre 511, das mit der Katalysatorschicht 505 gekoppelt ist, muss elektrisch kontaktiert werden, um zwischen den beiden Endabschnitten 511a, 511b der Nanoröhre 511 den elektrischen Widerstand der Nanoröhre 511 erfassen zu können.

Nach Durchführen dieser Verfahrensschritte wird die in **Fig. 5D** gezeigte Schichtstruktur 513 erhalten, die als Gassensor verwendet werden kann. Es ist zu betonen, dass die Verwendung der Nanoröhren-Anordnung der Erfindung als Gassensor nicht auf das in **Fig. 5D** gezeigte Ausführungsbeispiel beschränkt ist. Beispielsweise können mehrere Nanoröhren 511 elektrisch in Reihe geschaltet werden, um den Wert des zu erfassenden Gesamtwiderstandes zu erhöhen, und um so die Empfindlichkeit der Gassensor-Anordnung zu erhöhen. Alternativ können auch mehrere Nanoröhren 511 parallel geschaltet werden, um separat für jede Nanoröhre deren elektrischen Widerstand zu erfassen, und so über eine Mehrfachmessung eine Erhöhung der Nachweisgenauigkeit zu erreichen. Auch kann ein Teil der Nanoröhren 511 parallel und ein anderer Teil der Nanoröhren 511 in Serie geschaltet werden. Ferner ist die Funktionsweise der Nanoröhren-Anordnung als Gassensor nicht darauf beschränkt, dass der elektrische Widerstand der Nanoröhre 511 erfasst wird. Es kann auch jeder andere physikalische Parameter der Nanoröhre 511, der auf eine zu erfassende physikalische Größe sensitiv ist, auf eine andere Weise als elektrisch gemessen werden.

In diesem Dokument sind folgende Veröffentlichungen zitiert:
[1] Harris, PJF (1999) "Carbon Nanotubes and Related Structures - New Materials for the Twenty-first Century.", Cambridge University Press, Cambridge
[2] Dekker, C et al. (1999) "Carbon Nanotubes as Molecular Quantum Wires", Physics Today 5/99:22-28
[3] Kong, J et al. (2000) "Nanotube Molecular Wires as Chemical Sensors" Science 287:622-625
[4] Fan, S et al. (1999) "Self-Ordered regular arrays of carbon-nanotubes and their field emission properties" Science 283:512-514
[5] Suh, JS et al. (1999) "Highly ordered two dimensional carbon nanotube arrays" ApplPhysLett 75/14:2047-2049
[6] Soh, HT, Quate, CF, Morpurgo, AF, Marcus, CM, Kong, J, Dai, H (1999) "Integrated nanotube circuits: Controlled growth and ohmic contacting of singlewalled carbon nanotubes" Applied Physics Letters 75 (5) : 627-629
[7] US 2002/014667
[8] WO 01 44796

### Bezugszeichenliste

- 100: Nanoröhren-Anordnung
- 101: Substrat
- 102: Katalysatorschicht
- 103: Nanoröhre
- 103a: Endabschnitt der Nanoröhre
- 103b: Mittenabschnitt der Nanoröhre
- 104: elektrisch isolierende Schicht
- 105: Schaltkreiseinrichtung
- 106: weitere elektrisch isolierende Schicht
- 107: Schicht zur Verhinderung von Diffusion
- 108: Anschlusselektrode
- 110: Nanoröhren-Anordnung
- 120: Nanoröhren-Anordnung
- 200: Gassensor
- 201: strukturiertes Substrat
- 202: elektrisch isolierende Schicht
- 203: elektrisch leitfähige Katalysatorschicht
- 204: weitere elektrisch isolierende Schicht
- 205: Kohlenstoffnanoröhre
- 205a: Mittenabschnitt der Nanoröhre
- 205b: Endabschnitt der Nanoröhre
- 206: Elektrode
- 300: Schichtanordnung
- 301: elektrisch isolierende Schicht
- 302: Substrat
- 303: Katalysatorschicht
- 304: Schichtanordnung
- 305: weitere elektrisch isolierende Schicht
- 306: Schichtanordnung
- 307: Schichtanordnung
- 308: Graben
- 309: Schichtanordnung
- 310: Pore
- 311: Schichtanordnung
- 312: Nanoröhre
- 313: Schichtanordnung
- 400: Schichtanordnung
- 401: elektrisch isolierende Schicht
- 402: Substrat
- 403: Graben
- 404: Schichtanordnung
- 405: Katalysatorschicht
- 406: Schichtanordnung
- 407: weitere elektrisch isolierende Schicht
- 408: Pore
- 409: Schichtanordnung
- 410: Nanoröhre
- 411: Schichtanordnung
- 412: Nanoröhre
- 413: Schichtanordnung
- 500: Schichtanordnung
- 501: erste elektrisch isolierende Schicht
- 502: zweite elektrisch isolierende Schicht
- 503: Substrat
- 504: Schichtanordnung
- 505: Katalysatorschicht
- 506: weitere elektrisch isolierende Schicht
- 507: Graben
- 508: Pore
- 509: Schichtanordnung
- 510: Nut
- 511: Nanoröhre
- 511a: Endabschnitt der Nanoröhre
- 511b: anderer Endabschnitt der Nanoröhre
- 512: elektrische Kontaktierung
- 513: Schichtstruktur

## Patentansprüche

1. Nanoröhren-Anordnung
• mit einem Substrat;
• mit einer Katalysatorschicht, die einen oder mehrere Teilbereiche aufweist, auf der Oberfläche des Substrats;
• mit mindestens einer parallel zur Oberfläche des Substrats auf der Oberfläche der Katalysatorschicht angeordneten Nanoröhre;
• mit einer Pore, wobei mittels der Pore die Aufwachsrichtung der Nanoröhre ausgehend von der Katalysatorschicht und parallel zur Oberfläche des Substrats vorgegeben ist.

2. Nanoröhren-Anordnung nach Anspruch 1, ferner aufweisend eine elektrisch isolierende Schicht zwischen dem Substrat und der Katalysatorschicht.

3. Nanoröhren-Anordnung nach Anspruch 2, bei der die elektrisch isolierende Schicht eine derartige Topographie aufweist, dass die mindestens eine Nanoröhre in ihren Endabschnitten auf der elektrisch isolierenden Schicht aufliegt und in ihrem Mitteriabschnitt frei liegt.

4. Nanoröhren-Anordnung nach einem der Ansprüche 1 bis 3, bei der die Teilbereiche der Katalysatorschicht voneinander entkoppelt sind und/oder bei der die Nanoröhren voneinander entkoppelt sind.

5. Nanoröhren-Anordnung nach einem der Ansprüche 1 bis 4, ferner aufweisend eine Schaltkreiseinrichtung, mittels derer die Nanoröhren einzeln ansteuerbar und/oder auslesbar sind.

6. Nanoröhren-Anordnung nach einem der Ansprüche 1 bis 5, bei der ferner mindestens einer der Teilbereiche der Katalysatorschicht zumindest teilweise von einer weiteren elektrisch isolierenden Schicht umgeben ist.

7. Nanoröhren-Anordnung nach Anspruch 6, bei der die elektrisch isolierende Schicht und die weitere elektrisch isolierende Schicht, zwischen denen die Katalysatorschicht angeordnet ist, seitlich über die Katalysatorschicht hinausstehen, um so die Pore auszubilden, durch welche die zur Oberfläche des Substrats parallele Aufwachsrichtung der Nanoröhre vorgebbar ist.

8. Nanoröhren-Anordnung nach Anspruch 7, bei der die elektrisch isolierende Schicht und/oder die weitere elektrisch isolierende Schicht aus einem oder einer Kombination der Materialien Siliziumnitrid und Siliziumdioxid hergestellt ist.

9. Nanoröhren-Anordnung nach einem der Ansprüche 1 bis 8, bei der ferner mindestens einer der Teilbereiche der Katalysatorschicht zumindest teilweise von einer Schicht zur Verhinderung von Diffusion umgeben ist.

10. Nanoröhren-Anordnung nach Anspruch 9, bei der die Schicht zur Verhinderung von Diffusion aus Tantalnitrid hergestellt ist.

11. Nanoröhren-Anordnung nach einem der Ansprüche 1 bis 10, bei der die Katalysatorschicht aus einem oder einer Kombination der Materialien Nickel, Eisen und Kobalt hergestellt ist.

12. Nanoröhren-Anordnung nach einem der Ansprüche 1 bis 11, bei der die Teilbereiche der Katalysatorschicht zueinander parallel angeordnet sind.

13. Nanoröhren-Anordnung nach einem der Ansprüche 1 bis 12, bei der die Anordnung als Gassensor verwendet wird.

14. Nanoröhren-Anordnung nach einem der Ansprüche 1 bis 13, ferner aufweisend ein in das Substrat integriertes Mittel zum Erfassen des elektrischen Widerstandes der mindestens einen Nanoröhre.

15. Nanoröhren-Anordnung nach einem der Ansprüche 1 bis 14, bei der die Nanoröhren Kohlenstoffnanoröhren sind.

16. Verfahren zum Herstellen einer Nanoröhren-Anordnung, bei dem
B: eine Katalysatorschicht auf der Oberfläche der Schichtanordnung aufgebracht wird, wobei die Katalysatorschicht einen oder mehrere Teilbereiche aufweist;
F: mindestens eine Nanoröhre auf einem freiliegenden Teil der Oberfläche eines Teilbereichs der Katalysatorschicht aufgewachsen wird, derart, dass die mindestens eine Nanoröhre parallel zur Oberfläche der Schichtanordnung angeordnet wird, wobei mittels einer Pore die Aufwachsrichtung der Nanoröhre ausgehend von der Katalysatorschicht und parallel zur Oberfläche des Substrats vorgegeben wird.

17. Verfahren nach Anspruch 16, bei dem ferner
A: die Schichtanordnung durch Aufbringen einer elektrisch isolierenden Schicht auf einem Substrat ausgebildet wird.

18. Verfahren nach Anspruch 16 oder 17, bei dem ferner
C: eine weitere elektrisch isolierende Schicht auf mindestens einen Teil der Oberfläche der Schichtanordnung aufgebracht wird, derart, dass die weitere elektrisch isolierende Schicht mindestens einen der Teilbereiche der Katalysatorschicht mindestens teilweise bedeckt.

19. Verfahren nach einem der Ansprüche 16 bis 18, bei dem ferner
D: ein Grabens in einen Oberflächenbereich der Schichtanordnung geätzt wird.

20. Verfahren nach einem der Ansprüche 16 bis 19, bei dem ferner
E: die Katalysatorschicht teilweise zurückgeätzt wird, derart, dass die elektrisch isolierende Schicht und die weitere elektrisch isolierende Schicht seitlich über die Katalysatorschicht hinausstehen, wodurch die Pore erzeugt wird, durch welche die zur Oberfläche des Substrats parallele Aufwachsrichtung der Nanoröhre vorgegeben wird.

21. Verfahren nach einem der Ansprüche 16 bis 20, bei dem in dieser Reihenfolge
A: eine Schichtanordnung durch Aufbringen einer elektrisch isolierenden Schicht auf einem Substrat ausgebildet wird;
B: eine Katalysatorschicht auf der Oberfläche der Schichtanordnung aufgebracht wird, wobei die Katalysatorschicht einen oder mehrere Teilbereiche aufweist;
C: eine weitere elektrisch isolierende Schicht auf mindestens einen Teil der Oberfläche der Schichtanordnung aufgebracht wird, derart, dass die weitere elektrisch isolierende Schicht mindestens einen der Teilbereiche der Katalysatorschicht mindestens teilweise bedeckt;
D: ein Grabens in einen Oberflächenbereich der Schichtanordnung geätzt wird;
E: die Katalysatorschicht teilweise zurückgeätzt wird, derart, dass die elektrisch isolierende Schicht und die weitere elektrisch isolierende Schicht seitlich über die Katalysatorschicht hinausstehen, wodurch die Pore erzeugt wird, durch welche die zur Oberfläche des Substrats parallele Aufwachsrichtung der Nanoröhre vorgegeben wird;
F: mindestens eine Nanoröhre auf einem freiliegenden Teil der Oberfläche eines Teilbereichs der Katalysatorschicht aufgewachsen wird, derart, dass die mindestens eine Nanoröhre parallel zur Oberfläche der Schichtanordnung angeordnet wird.

22. Verfahren nach Anspruch 21, bei dem die Reihenfolge der Schritt D nach Schritt A und vor Schritt B ausgeführt wird.

23. Verfahren nach einem der Ansprüche 16 bis 22, bei dem ferner zwischen mindestens einen Teilbereich der Katalysatorschicht und die an den mindestens einen Teilbereich der Katalysatorschicht angrenzenden Schichten zumindest teilweise mindestens eine Schicht zur Verhinderung von Diffusion eingebracht wird.

24. Verfahren nach einem der Ansprüche 18 bis 23, bei dem die elektrisch isolierende Schicht und/oder die weitere elektrisch isolierende Schicht aus einem oder einer Kombination der Materialien Siliziumnitrid und Siliziumdioxid hergestellt wird.

25. Verfahren nach Anspruch 23 oder 24, bei dem die Schicht zur Verhinderung von Diffusion aus Tantalnitrid hergestellt wird.

26. Verfahren nach einem der Ansprüche 16 bis 25, bei dem die Katalysatorschicht aus einem oder einer Kombination der Materialien Nickel, Eisen und Kobalt hergestellt wird.

27. Verfahren nach einem der Ansprüche 16 bis 26, bei dem die Katalysatorschicht, die einen oder mehrere Teilbereiche aufweist, auf der Oberfläche der Schichtanordnung aufgebracht wird, indem zunächst eine Schicht von Katalysatormaterial aufgebracht wird und diese dann mittels Elektronenstrahllithographie strukturiert wird.

28. Verfahren nach einem der Ansprüche 16 bis 27, bei dem die mindestens eine Nanoröhre auf einem freiliegenden Teil der Oberfläche eines Teilbereichs der Katalysatorschicht mittels Gasphasenepitaxie aufgewachsen wird.

29. Verfahren nach einem der Ansprüche 16 bis 28, bei dem die mindestens eine Nanoröhre eine Kohlenstoffnanoröhre ist.

## Claims

1. Nanotube array, comprising:
• a substrate;
• a catalyst layer, which includes one or more subregions, on the surface of the substrate;
• at least one nanotube arranged on the surface of the catalyst layer, parallel to the surface of the substrate;
• a pore, the pore being used to predetermine the direction of growth of the nanotube starting from the catalyst layer and parallel to the surface of the substrate.

2. The nanotube array as claimed in claim 1, further comprising an electrically insulating layer between the substrate and the catalyst layer.

3. The nanotube array as claimed in claim 2, in which the electrically insulating layer has a topography which is such that the at least one nanotube rests on the electrically insulating layer at its end sections and is free in its central section.

4. The nanotube array as claimed in one of claims 1 to 3, in which the subregions of the catalyst layer are decoupled from one another and/or in which the nanotubes are decoupled from one another.

5. The nanotube array as claimed in one of claims 1 to 4, further comprising a circuit device, by means of which the nanotubes can be driven and/or read individually.

6. The nanotube array as claimed in one of claims 1 to 5, in which further at least one of the subregions of the catalyst layer is at least partially surrounded by a further electrically insulating layer.

7. The nanotube array as claimed in claim 6, in which the electrically insulating layer and the further electrically insulating layer, between which the catalyst layer is arranged, project laterally beyond the catalyst layer, to form the pore which can be used to predetermine the direction of growth of the nanotube parallel to the surface of the substrate.

8. The nanotube array as claimed in claim 7, in which the electrically insulating layer and/or the further electrically insulating layer is made from one or a combination of the materials silicon nitride and silicon dioxide.

9. The nanotube array as claimed in one of claims 1 to 8, in which, furthermore, at least one of the subregions of the catalyst layer is at least partially surrounded by a layer for preventing diffusion.

10. The nanotube array as claimed in claim 9, in which the layer for preventing diffusion is made from tantalum nitride.

11. The nanotube array as claimed in one of claims 1 to 10, in which the catalyst layer is made from one or a combination of the materials nickel, iron and cobalt.

12. The nanotube array as claimed in one of claims 1 to 11, in which the subregions of the catalyst layer are arranged parallel to one another.

13. The nanotube array as claimed in one of claims 1 to 12, in which the array is used as a gas sensor.

14. The nanotube array as claimed in one of claims 1 to 13, further comprising a means, which is integrated in the substrate, for recording the electrical resistance of the at least one nanotube.

15. The nanotube array as claimed in one of claims 1 to 14, in which the nanotubes are carbon nanotubes.

16. A method for producing a nanotube array, in which
B: a catalyst layer is applied to the surface of the layer arrangement, the catalyst layer having one or more subregions; and
F: at least one nanotube is grown up on an uncovered part of the surface of a subregion of the catalyst layer, in such a manner that the at least one nanotube is arranged parallel to the surface of the layer arrangement, the direction of growth of the nanotube starting from the catalyst layer and parallel to the surface of the substrate being predetermined by means of a pore.

17. The method as claimed in claim 16, in which further
A: the layer arrangement is formed by applying an electrically insulating layer to a substrate.

18. The method as claimed in claim 16 or 17, in which further
C: a further electrically insulating layer is applied to at least a part of the surface of the layer arrangement, in such a manner that the further electrically insulating layer at least partially covers at least one of the subregions of the catalyst layer.

19. The method as claimed in one of claims 16 to 18, in which further
D: a trench is etched into a surface region of the layer arrangement.

20. The method as claimed in one of claims 16 to 19, in which further
E: the catalyst layer is partially etched back in such a manner that the electrically insulating layer and the further electrically insulating layer project laterally beyond the catalyst layer, with the result that the pore which predetermines the direction of growth of the nanotube parallel to the surface of the substrate is produced.

21. A method for producing a nanotube array according to one of claims 16 to 20, in which in this order:
A: a layer arrangement is formed by applying an electrically insulating layer to a substrate;
B: a catalyst layer is applied to the surface of the layer arrangement, the catalyst layer having one or more subregions;
C: a further electrically insulating layer is applied to at least part of the surface of the layer arrangement, in such a manner that the further electrically insulating layer at least partially covers at least one of the subregions of the catalyst layer;
D: a trench is etched into a surface region of the layer arrangement;
E: the catalyst layer is partially etched back in such a manner that the electrically insulating layer and the further electrically insulating layer project laterally beyond the catalyst layer, with the result that the pore which predetermines the direction of growth of the nanotube parallel to the surface of the substrate is produced;
F: at least one nanotube is grown on an uncovered part of the surface of a subregion of the catalyst layer in such a manner that the at least one nanotube is arranged parallel to the surface of the layer arrangement.

22. A method as claimed in claim 21, in which in the order step D is carried out after step A and before step B.

23. The method as claimed in one of claims 16 to 22, in which further at least one layer for preventing diffusion is introduced at least in part between at least one subregion of the catalyst layer and the layers which adjoin the at least one subregion of the catalyst layer.

24. The method as claimed in one of claims 18 to 23, in which further the electrically insulating layer and/or the further electrically insulating layer is made from one or a combination of the materials silicon nitride and silicon dioxide.

25. The method as claimed in claim 23 or 24, in which the layer for preventing diffusion is made from tantalum nitride.

26. The method as claimed in one of claims 16 to 25, in which the catalyst layer is made from one or the combination of the materials nickel, iron and cobalt.

27. The method as claimed in one of claims 16 to 26, in which the catalyst layer which has one or more subregions is applied to the surface of the layer arrangement by first of all a layer of catalyst material being applied and this layer of catalyst material then being patterned by means of electron beam lithography.

28. The method as claimed in one of claims 16 to 27, in which the at least one nanotube is grown on an uncovered part of the surface of a subregion of the catalyst layer by means of vapor phase epitaxy.

29. The method as claimed in one of claims 16 to 28, in which the at least one nanotube is a carbon nanotube.

## Revendications

1. Ensemble à nanotubes
• comprenant un substrat ;
• comprenant une couche de catalyseur, qui a une zone partielle ou plusieurs zones partielles à la surface du substrat ;
• comprenant au moins un nanotube disposé parallèlement à la surface du substrat sur la surface de la couche de catalyseur ;
• comprenant un pore, dans lequel la direction de croissance des nanotubes, en partant de la couche de catalyseur et parallèlement à la surface du substrat, est prescrite au moyen du pore.

2. Ensemble à nanotubes suivant la revendication 1, comportant en outre une couche isolante du point de vue électrique entre le substrat et la couche de catalyseur.

3. Ensemble à nanotubes suivant la revendication 2, dans lequel la couche isolante du point de vue électrique a une topographie telle que le au moins un nanotube s'applique dans ses tronçons d'extrémité sur la couche isolante du point de vue électrique et est à découvert dans son tronçon médian.

4. Ensemble à nanotubes suivant l'une des revendications 1 à 3, dans lequel les zones partielles de la couche de catalyseur sont découplées les unes des autres et/ou dans lequel les nanotubes sont découplés les uns des autres.

5. Ensemble à nanotubes suivant l'une des revendications 1 à 4, comportant en outre un dispositif à circuit de commutation, au moyen duquel les nanotubes peuvent être commandés et/ou lus individuellement.

6. Ensemble à nanotubes suivant l'une des revendications 1 à 5, dans lequel, en outre, au moins l'une des zones partielles de la couche de catalyseur est entourée au moins en partie d'une autre couche isolante du point de vue électrique.

7. Ensemble à nanotubes suivant la revendication 6, dans lequel la couche isolante du point de vue électrique et l'autre couche isolante du point de vue électrique, entre lesquelles la couche de catalyseur est disposée, dépassent latéralement de la couche de catalyseur, pour former ainsi les pores, par lesquels la direction de croissance des nanotubes, parallèlement à la surface du substrat, peut être prescrite.

8. Ensemble à nanotubes suivant la revendication 7, dans lequel la couche isolante du point de vue électrique et/ou l'autre couche isolante du point de vue électrique est en l'un ou en une combinaison des matériaux nitrure de silicium et dioxyde de silicium.

9. Ensemble à nanotubes suivant l'une des revendications 1 à 8, dans lequel en outre, au moins l'une des zones partielles de la couche de catalyseur est entourée au moins en partie d'une couche pour empêcher la diffusion.

10. Ensemble à nanotubes suivant la revendication 9, dans lequel la couche pour empêcher la diffusion est en nitrure de tantale.

11. Ensemble à nanotubes suivant l'une des revendications 1 à 10, dans lequel la couche de catalyseur est en l'un ou en une combinaison des matériaux nickel, fer et cobalt.

12. Ensemble à nanotubes suivant l'une des revendications 1 à 11, dans lequel les zones partielles de la couche de catalyseur sont disposées parallèlement les unes aux autres.

13. Ensemble à nanotubes suivant l'une des revendications 1 à 12, dans lequel l'ensemble est utilisé comme détecteur de gaz.

14. Ensemble à nanotubes suivant l'une des revendications 1 à 13, comportant, en outre, un moyen intégré dans le substrat de détection de la résistance électrique du au moins un nanotube.

15. Ensemble à nanotubes suivant l'une des revendications 1 à 14, dans lequel les nanotubes sont des nanotubes en carbone.

16. Procédé de fabrication d'un ensemble à nanotubes, dans lequel
B : on dépose une couche de catalyseur sur la surface de l'ensemble de couches, la couche de catalyseur ayant une zone partielle ou plusieurs zones partielles ;
F : on fait croître au moins un nanotube sur une partie dégagée de la surface d'une zone partielle de la couche de catalyseur, de manière à ce que le au moins un nanotube soit disposé parallèlement à la surface de l'ensemble de couches, la direction de croissance du nanotube, en partant de la couche de catalyseur et parallèlement à la surface du substrat, étant prescrite au moyen d'un pore.

17. Procédé suivant la revendication 16, dans lequel en outre
A : on forme l'ensemble de couches par dépôt d'une couche isolante du point de vue électrique sur un substrat.

18. Procédé suivant la revendication 16 ou 17, dans lequel en outre
C : on dépose une autre couche isolante du point de vue électrique sur au moins une partie de la surface de l'ensemble de couches, de manière à ce que l'autre couche isolante du point de vue électrique recouvre au moins en partie au moins l'une des zones partielles de la couche de catalyseur.

19. Procédé suivant l'une des revendications 16 à 18, dans lequel en outre
D : on ménage par attaque un sillon dans une zone de surface de l'ensemble de couches.

20. Procédé suivant l'une des revendications 16 à 19, dans lequel en outre
E : on attaque en retrait, en partie, la couche de catalyseur, de manière à ce que la couche isolante du point de vue électrique et l'autre couche isolante du point de vue électrique dépassent latéralement de la couche de catalyseur, en produisant ainsi les pores par lesquels la direction de croissance des nanotubes parallèlement à la surface du substrat est prescrite.

21. Procédé suivant l'une des revendications 16 à 20, dans lequel, successivement
A : on forme un ensemble de couche par dépôt d'une couche isolante du point de vue électrique sur un substrat ;
B : on dépose une couche de catalyseur sur la surface de l'ensemble de couches, la couche de catalyseur ayant une zone partielle ou plusieurs zones partielles ;
C : on dépose une autre couche isolante du point de vue électrique sur au moins une partie de la surface de l'ensemble de couches, de manière à ce que l'autre couche isolante du point de vue électrique recouvre, au moins en partie, au moins l'une des zones partielles de la couche de catalyseur ;
D : on ménage par attaque un sillon dans une partie de surface de l'ensemble de couches ;
E : on attaque en retrait, en partie, la couche de catalyseur, de manière à ce que la couche isolante du point de vue électrique et l'autre couche isolante du point de vue électrique dépassent latéralement de la couche de catalyseur, en produisant ainsi les pores, par lesquels la direction de croissance des nanotubes parallèlement au substrat est prescrite ;
F : on fait croître au moins un nanotube sur une partie dégagée de la surface d'une zone partielle de la couche de catalyseur, de manière à ce que le au moins un nanotube soit disposé parallèlement à la surface de l'ensemble de couches.

22. Procédé suivant la revendication 21, dans lequel on effectue dans l'ordre le stade D après le stade A et avant le stade B.

23. Procédé suivant l'une des revendications 16 à 22, dans lequel en outre, on introduit entre au moins une zone partielle de la couche de catalyseur et les couches voisines de la au moins une zone partielle de la couche de catalyseur, au moins en partie, au moins une couche pour empêcher la diffusion.

24. Procédé suivant l'une des revendications 18 à 23, dans lequel la couche isolante du point de vue électrique et/ou l'autre couche isolante du point de vue électrique est en l'un ou en une combinaison des matériaux nitrure de silicium et dioxyde de silicium.

25. Procédé suivant la revendication 23 ou 24, dans lequel la couche pour empêcher la diffusion est en nitrure de tantale.

26. Procédé suivant l'une des revendications 16 à 25, dans lequel la couche de catalyseur est en l'un ou en une combinaison des matériaux nickel, fer et cobalt.

27. Procédé suivant l'une des revendications 16 à 26, dans lequel la couche de catalyseur, qui a une zone partielle ou plusieurs zones partielles, est déposée sur la surface de l'ensemble de couches, en déposant d'abord une couche de matières de catalyseur et en la structurant ensuite au moyen d'une lithographie par faisceau d'électrons.

28. Procédé suivant l'une des revendications 16 à 27, dans lequel on fait croître le au moins un nanotube sur une partie dégagée de la surface d'une zone partielle de la couche de catalyseur, au moyen d'une épitaxie en phase gazeuze.

29. Procédé suivant l'une des revendications 16 à 28, dans lequel le au moins un nanotube est un nanotube de carbone.
